(19) Europäisches Patentamt European Patent Office Office européen des brevets

(11) **EP 2 136 231 A1**

(12) **EUROPEAN PATENT APPLICATION**

(43) Date of publication:
**23.12.2009  Bulletin 2009/52**

(51) Int Cl.:
*G02B 17/08* (2006.01)    *G03F 7/20* (2006.01)

(21) Application number: **08010944.0**

(22) Date of filing: **17.06.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS**<br><br>(71) Applicant: **Carl Zeiss SMT AG**<br>**73447 Oberkochen (DE)** | (72) Inventor: **Dodoc, Aurelian**<br>**89522 Heidenheim (DE)**<br><br>(74) Representative: **Patentanwälte**<br>**Ruff, Wilhelm, Beier, Dauster & Partner**<br>**Kronenstrasse 30**<br>**70174 Stuttgart (DE)** |

(54) **High aperture catadioptric system**

(57)    An optical system forming an image of a pattern provided in an object plane of the optical system in an image plane of the optical system, comprises: a plurality of non-parallel optical axis segments; a plurality of intermediate images; and a plurality of mirrors. Radiation emerging from an intermediate image is incident in this order on a first mirror positioned optically remote from a pupil position, a second mirror positioned optically near to a pupil position to form a pupil mirror, and a third mirror positioned optically remote from a pupil position, prior to forming another intermediate image, wherein the first mirror a first concave mirror, and the third mirror is a second concave mirror.

Fig. 2

**Description**

BACKGROUND OF THE INVENTION

Field of the Invention

The invention relates to a catadioptric optical system which may be used as a projection objective in a microlithographic projection exposure apparatus to expose a radiation-sensitive substrate arranged in the region of an image surface of the projection objective with at least one image of pattern of a mask that is arranged in the region of an object surface of the projection objective. The invention also relates to a projection exposure apparatus which includes such catadioptric optical system.

Description of the Related Art

Microlithographic projection exposure methods and apparatus are used to fabricate semiconductor components and other finely patterned components. A microlithographic exposure process involves using a mask (reticle) that carries or forms a pattern of a structure to be imaged, for example a line pattern of a layer of a semiconductor component. The pattern is positioned in a projection exposure apparatus between an illumination system and a projection objective in a region of the object surface of the projection objective. Primary radiation from the ultraviolet electromagnetic spectrum (UV radiation) is provided by a primary radiation source and transformed by optical components of the illumination system to produce illumination radiation directed at the pattern of the mask. The radiation modified by the mask and the pattern passes through the projection objective, which forms an image of the pattern in the image surface of the projection objective, where a substrate to be exposed is arranged. The substrate, e.g. a semiconductor wafer, normally carries a radiation-sensitive layer (photoresist).

In order to create even finer structures, it is sought to both increase the image-side numerical aperture (NA) of the projection objective and employ shorter wavelengths, preferably ultraviolet radiation with wavelengths less than about 260 nm, for example 248 nm, 193 nm or 157 nm.

Purely refractive projection objectives have been predominantly used for optical lithography in the past. However, correction of elementary aberrations, such as correction of chromatic aberrations and correction for the Petzval sum (image field curvature) become more difficult as NA is increased and shorter wavelengths are used.

One approach for obtaining a flat image surface and good correction of chromatic aberrations is the use of catadioptric optical systems, which combine both refracting elements, such as lenses, and reflecting elements with optical power, such as at least one concave mirror. While the contributions of positive-powered and negative-powered lenses in an optical system to overall power, image field curvature and chromatic aberrations are opposite to each other, a concave mirror has positive power like a positive-powered lens, but the opposite effect on image field curvature without contributing to chromatic aberrations.

A concave mirror is difficult to integrate into an optical system, since it sends the radiation right back in the direction it came from. Configurations integrating a concave mirror without causing problems due to beam vignetting and pupil obscuration are desirable.

A variety of concepts with specific advantages and drawbacks have been used in the past. Catadioptic projection objectives without intermediate image or with one or more real intermediate images have been designed. Separation of a projection beam section directed at a concave mirror and a projection beam section reflected by a concave mirror may be accomplished in a variety of ways. Polarization selective physical beam splitting may be employed. Alternatively, geometrical beam separation may be employed, for example by using one or more planar deflecting mirrors to fold the optical axis of the projection objective. Catadioptric projection objectives with one straight, unfolded optical axis have also been designed.

Further, the overall size of the optical systems both with regard to diameter of optical components and with regard to system length tends to increase as the image-side NA is increased. In this regard, high prices of transparent materials with sufficient optical quality and sizes large enough for fabricating large lenses represent problems. Additionally, installation space for incorporating a projection objective into a microlithographic projection exposure apparatus may be limited. Therefore, measures that allow reducing the number and sizes of lenses and simultaneously contribute to maintaining, or even improving, imaging fidelity are desired.

SUMMARY OF THE INVENTION

It is one object of the invention to provide an optical system with multiple mirrors which is capable to function at high image-side numerical aperture and which can be manufactured at moderate production costs.

It is another object of the invention to provide a folded catadioptric optical system including at least one concave mirror which is incorporated to the optical system in a mechanically stable fashion.

To address these and other objects the invention, according to one formulation of the invention, provides an optical system forming an image of a pattern provided in an object plane of the optical system in an image plane of the optical system, comprising:

a plurality of non-parallel optical axis segments;
a plurality of intermediate images; and
a plurality of mirrors;

wherein radiation emerging from a first intermediate image is incident in this order on a first mirror positioned optically remote from a pupil position, a second mirror positioned optically near to a pupil position to form a pupil mirror, and a third mirror positioned optically remote from a pupil position, prior to forming a second intermediate image, wherein the first mirror (positioned optically remote from a pupil position) is a first concave mirror, and the third mirror (positioned optically remote from a pupil position) is a second concave mirror.

In this definition, the terms "first intermediate image" and "second intermediate image" refer to relative positions along a radiation path in a sense that the first intermediate image is formed between the object surface and the second intermediate image, and the second intermediate image is formed between the first intermediate image and the image surface. There may be no intermediate image between the first and second intermediate image, but it is possible that one or more intermediate images are formed between the first and second intermediate image.

The optical system may comprise: a first dioptric imaging system forming an intermediate image and a second catadioptric imaging system forming the final image in the image plane, and may comprise in this order the first mirror, the second mirror (pupil mirror), and the third mirror.

The optical system may comprise: a first catadioptric imaging system forming an intermediate image and a second dioptric imaging system forming the final image, wherein the first catadioptric objective part may comprise in this order the first mirror, the second mirror (pupil mirror), and the third mirror.

The optical system may comprise: a first dioptric imaging system forming an intermediate image, a second catadioptric or catoptric imaging system forming a second intermediate image, and a third dioptric imaging system forming the final image, wherein the second catadioptric objective part may comprise in this order the first mirror, the second mirror (pupil mirror), and the third mirror.

The optical system may comprise: a first catadioptric imaging system forming an intermediate image, and a second catadioptric imaging system forming the final image, and may comprise in this order the first mirror, the second mirror (pupil mirror), and a third mirror.

The optical system may comprise: a first catadioptric imaging system forming an intermediate image and a second catadioptric imaging system forming a further intermediate and a third catadioptric imaging system forming the final image, and may comprise in this order the first mirror, the second mirror (pupil mirror), and the third mirror.

The previous and other properties can be seen not only in the claims but also in the description and the drawings, wherein individual characteristics may be used either alone or in sub-combinations as an embodiment of the invention and in other areas and may individually represent advantageous and patentable embodiments.

BRIEF DESCRIPTION OF THE DRAWINGS

Fig. 1     shows a schematic drawing of an embodiment of a projection exposure apparatus for microlithography having an illumination system and a projection objective;

Fig. 2     shows a schematic illustration of a first embodiment of a catadioptric projection objective;

Fig. 3     shows schematic representations of various positions of intermediate images relative to folding mirrors;

Fig. 4     shows a schematic illustration of a second embodiment of a catadioptric projection objective;

Fig. 5     shows schematically different configurations of pupil mirrors and associated folding mirrors;

Fig. 6     shows a schematic illustration of a third embodiment of a catadioptric projection objective;

Fig. 7     shows a schematic illustration of a fourth embodiment of a catadioptric projection objective;

Fig. 8 shows in 8A a second objective part including a free-standing negative lens between concave mirrors and the pupil mirror and in 8B an embodiment of a second objective part having first and second concave mirrors designed as Mangin mirrors;

Fig. 9 shows a schematic representation of footprints of the radiation beam on two concave mirrors optically remote from a pupil surface and on a pupil mirror;

Fig. 10 shows schematically a second objective part with an exchangeable pupil mirror;

Fig. 11 shows two examples of second objective parts with an exchangeable transparent optical element in a double pass region in front of the pupil mirror;

Fig. 12 shows in 12A various schematic views of a pupil mirror having an associated pupil mirror manipulator to continuously vary the shape of the reflective surface of the pupil mirror; and in 12B various schematic views of a pupil mirror having an associated transparent optical element with integrated conductive tracks generating a two-dimensional array of electrically controllable heating zones;

Fig. 13 shows schematically a second objective part having baffles to reduce flare in the image;

Fig. 14 shows schematic representation of various field geometries of the effective object field;

Fig. 15 shows a schematic illustration of a fifth embodiment of a catadioptric projection objective having four intermediate images and a concave pupil mirror;

Fig. 16 shows in 16A a meridional section of a first working example of a catadioptric projection objective having first and second concave mirrors formed on a common substrate and a plane pupil mirror formed integral with first and second folding mirrors, and in 16B a detail of a variant optically identical to Fig. 16A, with physically separate pupil mirror and folding mirrors;

Fig. 17 shows a second working example of a catadioptric projection objective generally in accordance with the layout in Fig. 6(b);

Fig. 18 shows a third working example of a catadioptric projection objective generally in accordance with the layout in Fig. 15;

Fig. 19 shows a fourth working example of a catadioptric projection objective having a lens element of high refractive index adjacent to the image surface; and

Fig. 20 shows a fifth working example of a catadioptric projection objective with a lens element of high refractive index adjacent to the image surface.

DETAILED DESCRIPTION OF THE PREFERRED EMBODIMENTS

In the following description of preferred embodiments, the term "optical axis" refers to a straight line or a sequence of a straight-line segments passing through the centers of curvature of optical elements. The optical axis can be folded by folding mirrors (deflecting mirrors) such that angles are included between subsequent straight-line segments of the optical axis. In the examples presented below, the object is a mask (reticle) bearing the pattern of a layer of an integrated circuit or some other pattern, for example, a grating pattern. The image of the object is projected onto a wafer serving as a substrate that is coated with a layer of photoresist, although other types of substrates, such as components of liquid-crystal displays or substrates for optical gratings, are also feasible.

Where tables are provided to disclose the specification of a design shown in a figure, the table or tables are designated by the same numbers as the respective figures. Corresponding features in the figures are designated with like or identical reference identifications to facilitate understanding. Where lenses are designated, an identification L3-2 denotes the second lens in the third objective part (when viewed in the radiation propagation direction).

Concatenated imaging systems are described. The term "concatenated system" as used here refers to an optical imaging system that includes two or more imaging subsystems (also denoted as imaging objective parts) that are linked together at intermediate images, where an intermediate image is the image formed by a subsystem upstream of the intermediate image and serves as the object of a subsystem downstream of the intermediate image. Throughout this specifications the terms "upstream" and "downstream" refer to relative positions to an optical element or an optical surface along the optical path through the optical system, where "upstream" relates to a position before rays impinge on the respective optical element or optical surface, and "downstream" refers to a position after rays emerge from the respective optical element or optical surface.

In this specification, a "subsystem" or "objective part" is an optical system designed to image an object arranged on an entry side field surface of the subsystem onto an exit side field surface of the subsystem optically conjugate to the entry side field surface without forming an intermediate image. Subsystems may therefore also be denoted as "imaging subsystem" in the following. An optical axis of a subsystem (or objective part) may be folded at a planar mirror surface or may be unfolded (straight).

The term "imaging system" has a broader meaning than "subsystem" or "objective part". Each subsystem or objective part is an imaging system not forming an intermediate image between its entry side field surface and its exit side field surface optically conjugate to the entry side field surface. In contrast, the term "imaging system" also encompasses imaging systems were at least one intermediate image is formed between its entry side field surface and its exit side field surface optically conjugate to the entry side field surface.

In some concatenated system one or more refractive (dioptric) subsystems are combined with one or more catadioptric or catoptric subsystems. In a refractive subsystem, all optical elements having refractive power are transparent lenses. In a catadioptric or catoptric subsystem at least one curved mirror having optical power, for example a concave mirror, contributes to image formation. One or more planar folding mirrors having no optical power may be included in a refractive subsystem and/or in a catadioptric or catoptric subsystem.

In schematic representations below the folded optical axis may be characterized by a sequence of a dash-dotted lines representing optical axis segments. Single lenses or lens groups having overall positive refractive power are symbolized by double arrows having their arrow heads facing outside. Single lenses or lens groups having overall negative refractive power are symbolized by double arrows having arrow heads facing inwards. An object or intermediate image IMI or final image defining a field surface is symbolized by an arrow perpendicular to a respective optical axis OA.

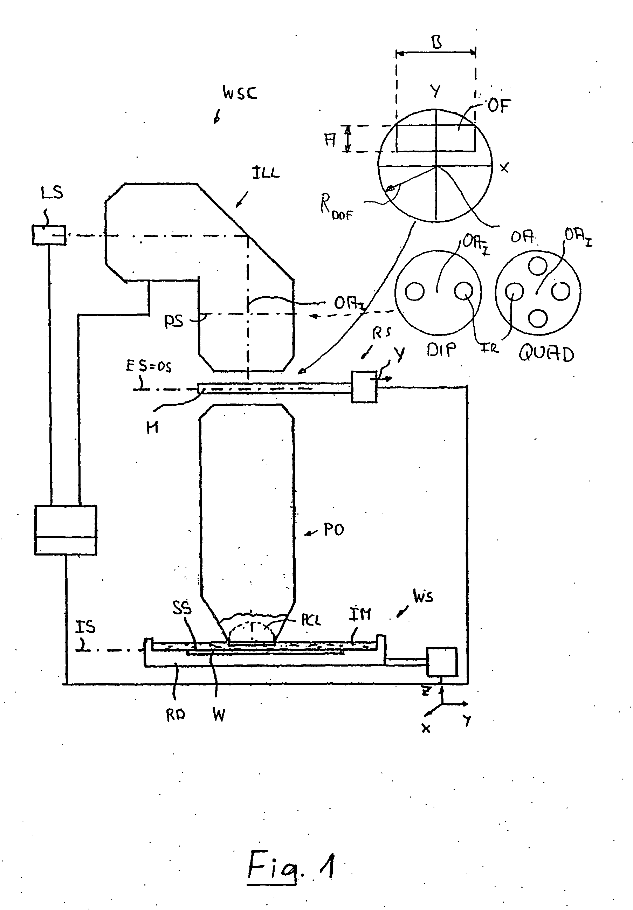

Figure 1 shows schematically a microlithographic projection exposure system in the form of a wafer scanner WSC, which is provided for fabricating large scale integrated semiconductor components by means of immersion lithography in a step-and-scan mode. The projection exposure system comprises an Excimer laser as light source LS having an operating wavelength of 193 nm. Other operating wavelengths, for example 157 nm or 248 nm, are possible. A downstream illumination system ILL generates, in its exit surface ES, a large, sharply delimited, homogeneously illuminated illumination field arranged off-axis with respect to the optical axis of the projection objective PO (which is coaxial with optical axis $OA_I$ of the illumination system in embodiments) and adapted to the telecentric requirements of the downstream catadioptric projection objective PO. Specifically, the exit pupil of the illumination system coincides with the entrance pupil of the projection objective for all field points. The multi-axis projection objective is shown schematically only to to facilitate illustration. The illumination system ILL has devices for selecting the illumination mode and, in the example, can be changed over between conventional on-axis illumination with a variable degree of coherence, and off-axis illumination, particularly annular illumination (having a ring shaped illuminated area in a pupil surface of the illumination system) and dipole or quadrupole illumination.

A device RS for holding and manipulating a mask M is arranged between the exit-side last optical element of the illumination system and the entrance of the projection objective such that a pattern - arranged on or provided by the mask - of a specific layer of the semiconductor component to be produced lies in the planar object surface OS (object plane) of the projection objective, said object plane coinciding with the exit plane EX of the illumination system. The device RS - usually referred to as "reticle stage" - for holding and manipulating the mask contains a scanner drive enabling the mask to be moved parallel to the object surface OS of the projection objective or perpendicular to the optical axis (z direction) of projection objective and illumination system in a scanning direction (y-direction) for scanning operation.

The size and shape of the illumination field provided by the illumination system determines the size and shape of the effective object field OF of the projection objective actually used for projecting an image of a pattern on a mask in the image surface of the projection objective. The slit-shaped effective object field has a height A parallel to the scanning direction and a width B > A perpendicular to the scanning direction and may be rectangular (as shown in the inset figure) or arcuate (ring field). An aspect ratio B/A may be in a range from B/A = 2 to B/A = 10, for example. The same applies for the illumination field. A circle with minimum radius $R_{DOF}$ around the effective object field and centred about the optical axis OA of the projection objective indicates the design object field including field points sufficiently corrected for aberrations to allow imaging with a specified performance and free of vignetting. The effective object field includes a subset of those field points.

The reduction projection objective PO is telecentric at the object and image side and designed to image an image of a pattern provided by the mask with a reduced scale of 4:1 onto a wafer W coated with a photoresist layer. Other reduction scales, e.g. 5:1 or 8:1 are possible. The wafer W serving as a light-sensitive substrate is arranged in such a way that the planar substrate surface SS with the photoresist layer essentially coincides with the planar image surface IS of the projection objective. The wafer is held by a device WS (wafer stage) comprising a scanner drive in order to move the wafer synchronously with the mask M in parallel with the latter, and with reduced speed corresponding to the reduction ratio of the projection objective. The device WS also comprises manipulators in order to move the wafer both in the Z direction parallel to the optical axis OA and in the X and Y directions perpendicular to said axis. A tilting device having at least one tilting axis running perpendicular to the optical axis is integrated.

The device WS provided for holding the wafer W (wafer stage) is constructed for use in immersion lithography. It comprises a receptacle device RD, which can be moved by a scanner drive and the bottom of which has a flat recess for receiving the wafer W. A peripheral edge forms a flat, upwardly open, liquid-tight receptacle for a liquid immersion medium IM, which can be introduced into the receptacle and discharged from the latter by means of devices that are not shown. The height of the edge is dimensioned in such a way that the immersion medium that has been filled in can completely cover the surface SS of the wafer W and the exit-side end region of the projection objective PO can dip into the immersion liquid given a correctly set operating distance between objective exit and wafer surface.

The projection objective PO has an immersion lens group formed by a plano-convex lens PCL, which is the last optical element nearest to the image surface IS. The planar exit surface of said lens is the last optical surface of the projection objective PO. During operation of the projection exposure system, the exit surface of the plano-convex lens PCL is partly or completely immersed in the immersion liquid IM and is wetted by the latter. In the exemplary case the immersion liquid has a refractive index $n_l \approx 1.65$ at 193 nm. The convex entry surface of plano-convex lens PCL is adjacent to a gas filling the space between this lens and a lens immediately upstream thereof on the object-side. The plano-convex lens forms a monolithic immersion lens group allowing the projection objective to operate at NA > 1 in an immersion operation.

In this application, the term "immersion lens group" is used for a single lens or a lens group including at least two cooperating optical elements providing a convex object-side entry surface bounding at a gas or vacuum and an image-side exit surface in contact with an immersion liquid in operation. The exit surface may be essentially planar. The immersion lens group guides the rays of the radiation beam from gas (or vacuum) into the immersion liquid.

Various different illumination settings may be set with the illumination system ILL. For example, where the pattern of the mask to be projected on the wafer essentially consists of parallel lines running in one direction, a dipole setting DIP (see left inset figure) may be utilized to increase resolution and depth of focus. To this end, adjustable optical elements in the illumination system are adjusted to obtain, in a pupil surface PS of the illumination system ILL, an intensity distribution characterized by two locally concentrated illuminated regions IR of large light intensity at diametrically opposed positions outside the optical axis OA and little or no light intensity on the optical axis. A similar inhomogeneous intensity distribution is obtained in pupil surfaces of the projection objective optically conjugate to the pupil surface of the illumination system.

The illumination setting may be changed to obtain, for example, conventional illumination (rotational symmetry around the optical axis) or quadrupole illumination (four-fold radial symmetry around the optical axis, see right hand side inset figure QUAD with four off-axis illuminated regions IR).

Illumination systems capable of optionally providing the described off-axis polar illumination modes are described, for example, in US 6,252,647 B1 or in applicant's patent application US 2006/005026 A1, the disclosure of which is incorporated herein by reference.

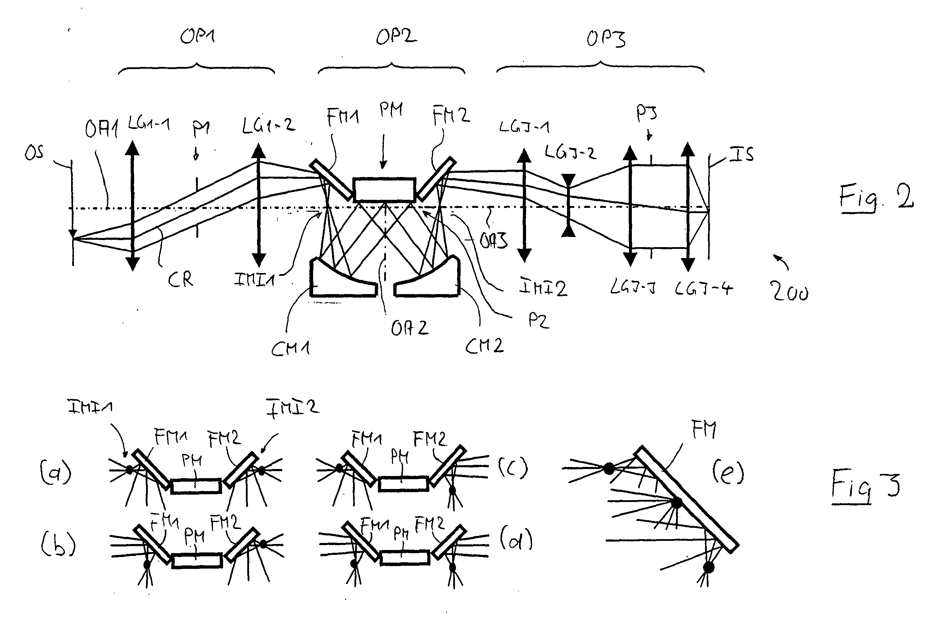

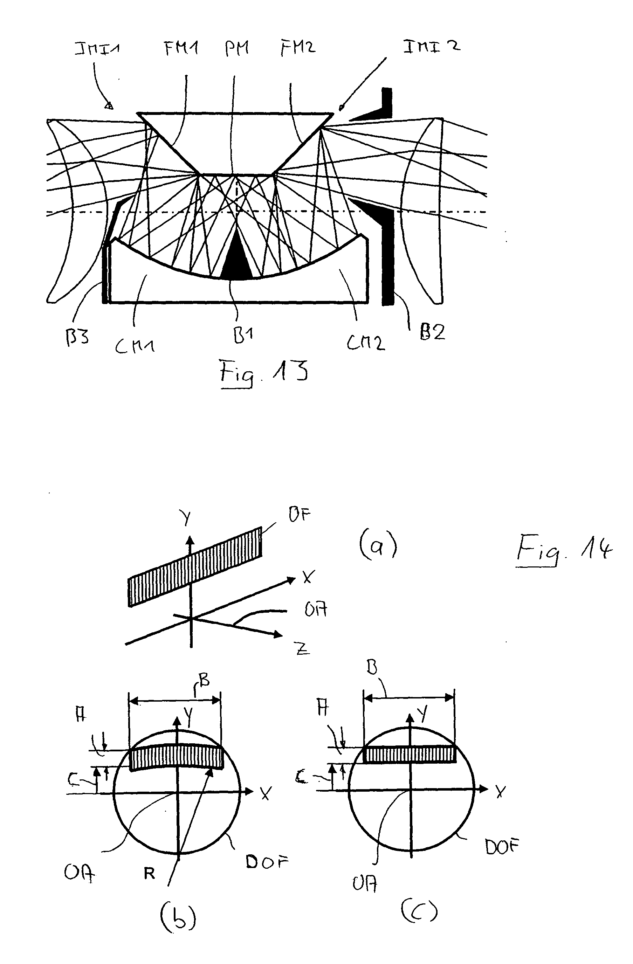

Figure 2 shows a schematic illustration of a lens section according to a first embodiment of a catadioptric projection objective. Projection objective 200 is designed to project an image of a pattern on a reticle arranged in the planar object surface OS (object plane) into the planar image surface IS (image plane) on a reduced scale while creating exactly two real intermediate images IMI1, IMI2. The rectangular (or arcuate) effective object field OF and image field IF are off-axis, i.e. entirely outside the optical axis OA (see Fig. 14 for various field geometries). A first refractive objective part OP1 is designed for imaging the pattern provided in the object surface into the first intermediate image IMI1. A second, catoptric (purely reflective) objective part OP2 images the first intermediate image IMI1 into the second intermediate image IMI2 at a magnification close to 1:(-1). A third, refractive objective part OP3 images the second intermediate image IMI2 onto the image surface IS with a strong reduction ratio.

Systems of the type shown in Fig. 2 are sometimes referred to as R-C-R system, where "R" denotes a refractive imaging system and "C" denotes a catadioptric (or catoptric) imaging system.

The path of a chief ray CR of an outer field point of the off-axis object field OF onto the meridional plane (drawing plane) is indicated in Fig. 2 in order to facilitate following the beam path of the projection beam. For the purpose of this application, the term "chief ray" (also known as principal ray) denotes a ray running from an outermost field point (farthest away from the optical axis) of the effectively used object field OF to the center of the entrance pupil. Using an off axis rectangular object field the chief ray of the objective may originate at the outermost field corner. Due to the rotational symmetry of the system the chief ray may be chosen from an equivalent field point in the meridional plane. This equivalent chief ray may not contribute to the imaging when an off axis object field with fold mirrors or other surfaces acting as baffles are used. In projection objectives being essentially telecentric on the object side, the chief ray emanates from the object surface parallel or at a very small angle with respect to the optical axis.

The imaging process is further characterized by the trajectory of marginal rays. A "marginal ray" as used herein is a ray running from an axial object field point (field point on the optical axis) to the edge of an aperture stop. That marginal ray may not contribute to image formation due to vignetting when an off-axis effective object field with fold mirrors or other surfaces acting as baffles is used. The chief ray and marginal ray are chosen to characterize optical properties of the projection objectives. The radial distance between such selected rays and the optical axis at a given axial position are denoted as "chief ray height" (CRH) and "marginal ray height" (MRH), respectively. The angle included between the chief ray and the optical axis is the chief ray angle CRA. The angle included between the marginal ray and the optical axis is the marginal ray angle MRA.

The projection objective is essentially telecentric in image space, i.e. the exit pupil is located essentially at infinity. This determines the position of the pupil surfaces in the subsystems being the conjugate planes to the exit pupil at infinity. The object space may be essentially telecentric as well, thus providing an entrance pupil essentially at infinity.

Three mutually conjugated pupil surfaces P1, P2 and P3 are formed at positions where the chief ray, being essentially telecentric in image space, intersects the optical axis. A first pupil surface P1 is formed in the first objective part between object surface and first intermediate image, a second pupil surface P2 is formed in the second objective part between first and second intermediate image, and a third pupil surface P3 is formed in the third objective part between second intermediate image and the image surface IS.

The first objective part includes a first positive lens group LG1-1 between the object surface OS and the first pupil surface P1, and a second positive lens group LG1-2 between the first pupil surface and the first intermediate image. The first objective part OP1 is designed such that the first intermediate image IMI1 has an appropriate size, position and correction status to serve as the object of a second objective part OP2. In some embodiments the first intermediate image IMI1 is corrected such that no caustic conditions are given at the optical surfaces adjacent to the first folding mirror FM1. The first objective part OP1 has a slightly magnifying (enlarging) effect. In some embodiments the condition $1.2 < |\beta_1| < 2.2$ holds, with $\beta_1$ being the magnification ratio of the first objective part.

The second objective part OP2 includes a first concave mirror CM1 positioned optically remote from the second pupil surface P2, a second mirror positioned optically near to the second pupil surface P2 to form a pupil mirror PM, and a concave third mirror, constituting a second concave mirror CM2, positioned optically remote from the second pupil surface. The mirrors are arranged such that radiation emerging from the first intermediate image IMI1 is incident in this order on the first concave mirror CM1, the pupil mirror PM, and the second concave mirror prior to forming the second intermediate image IMI2. A double pass region where the radiation passes twice in opposite directions is formed in front of the pupil mirror PM geometrically between the pupil mirror PM and the concave mirrors CM1 and CM2.

The third objective part has a first positive lens group LG3-1, a subsequent negative lens group LG3-2 and a subsequent positive lens group LG3-3 between the second intermediate image IMI2 and a third pupil surface P3, and a positive lens group LG3-4 between the third pupil surface P3 and the image surface. In preferred embodiments the third objective part provides the major contribution to overall reduction. For example, the magnification ratio $\beta_3$ of the third objective part may obey the condition $-0.15 \leq \beta_3 \leq -0.4$.

The first and second concave mirrors CM1, CM2 have a common axis of rotational symmetry, defining a second optical axis segment OA2 perpendicular to the first and third optical axis segments OA1, OA3 defined by the coaxial first and third objective parts OP1, OP3. In other embodiments the optical axis segment defined by the concave mirrors is inclined at a non-rectangular angle to the other optical axis segments, for example deviating by up to 5° or up to 10° or up to 15° from an orthogonal orientation.

The pupil mirror PM has a substantially planar reflecting surface perpendicular to the second optical axis segment OA2 and is arranged optically close to the second pupil surface P2 at a position where CRH « MRH, for example CRH < 0.5 * MRH or CRH < 0.1 * MRH. In contrast, both concave mirrors are optically remote from the second pupil surface and optically nearer to the field surfaces where the intermediate images are positioned, for example where CRH > MRH. In some embodiments the condition 2<CRH/MRH<7 holds for the position of the pupil mirror.

In other embodiments the pupil mirror is spherically or asherically curved. The pupil mirror may be a convex mirror or a concave mirror.

A first planar folding mirror FM is arranged optically close to the first intermediate image IMI1 at an angle of 45° to the optical axis OA such that it reflects the radiation coming from the object surface in the direction of the first concave mirror CM1. A second folding mirror FM2, having a planar mirror surface aligned at right angles to the planar mirror surface of the first folding mirror, reflects the radiation coming from the second concave mirror CM2 in the direction of the image surface, which is parallel to the object surface.

The folding mirrors FM1, FM2 are each located in the optical vicinity of, but at a small distance from the closest intermediate image. The expression "intermediate image" describes the area where adjacent aperture rays (rays running from one object field point to different locations in the entrance pupil) cross each other. In general this is an axial region which extends at least between a paraxial intermediate image and a marginal ray intermediate image. Depending on the correction state of the intermediate image, this area may extend over a certain axial range in which case, by way of example, the paraxial intermediate image may be located in the light path upstream or downstream of the marginal ray intermediate image, depending on the spherical aberration (overcorrection or undercorrection). For off-axis field points field aberrations, such as coma and astigmatism, may also influence the axial extension of an intermediate image. The paraxial intermediate image and the marginal ray intermediate image may also essentially coincide.

There are other ways to describe the general layout of optical systems generally constructed as embodiment of Fig. 2, having a first refractive objective part OP1 forming a first intermediate image IMI1, a second objective part OP2 including at least one concave mirror to form the second intermediate image IMI2, and a third, refractive objective part OP3 forming the final image in the image surface. For example, the first and second objective parts OP1, OP2 may be described as a catadioptric imaging system forming an intermediate image (second intermediate image IMI2) and including one intermediate image (first intermediate image IMI1) between its object surface OS and optically conjugated image surface where the second intermediate image is formed. In this description, the optical system comprises a first catadioptric imaging system (formed by first and second objective parts O-P1, OP2) forming an intermediate image (second intermediate image) and a second, refractive objective part (formed by third objective part OP3) forming the final image, wherein the first catadioptric objective part includes in this order a first mirror CM1 positioned optically remote from pupil position, a second mirror PM positioned optically near to a pupil position and a third mirror CM2 optically remote from a pupil position.

In an alternative way to describe the optical system, first refractive objective part OP1 forms an intermediate image and a second, catadioptric imaging system (formed by second objective part OP2 and third objective part OP3) forms the final intermediate image. In this description, the second intermediate image IMI2 is formed within the second catadioptric imaging system imaging the first intermediate image IMI1 onto a final image in the image surface IS. In this description, the second catadioptric objective part includes in this order a first mirror CM1 positioned optically remote from pupil position, a second mirror PM positioned optically near to a pupil position and a third mirror CM2 optically remote from a pupil position.

Some variants of optical positions of intermediate images are schematically shown in Fig. 3. In the figures, the intersection points of rays originating from a particular field point are indicated as black dots representing the position of the intermediate field points generated by the respective ray bundles.

In Fig. 3(a) the first intermediate image IMI1 is optically upstream of the first folding mirror FM1 and a second intermediate image IMI2 is optically downstream of the second folding mirror FM2. In Fig. 3(b) the first intermediate image IMI1 is formed optically downstream of first folding mirror FM1, which is therefore part of first objective part OP1. The second intermediate image is formed optically downstream of second folding mirror FM2, which is therefore part of the catoptric second objective part. In the configuration of Fig. 3(c) the first folding mirror FM1 is within the second objective part downstream of first intermediate image IMI1, whereas the second folding mirror FM2 is optically downstream of second intermediate image IMI2 and therefore part of third objective part OP3. Fig. 3(d) corresponds to the situation shown in Fig. 2 where first intermediate image IMI1 is formed optically downstream of first folding mirror FM1 and second intermediate image is formed optically upstream of second folding mirror FM2 such that both folding mirrors FM1, FM2 are located within the respective dioptric objective part OP1, OP3.

Depending on the correction status of the intermediate image the intermediate image may be formed in a curved intermediate image surface which may or may not overlap with the folding mirror. In Fig. 3(e) a center region of the intermediate image is formed very close to or on the reflective surface of folding mirror FM, whereas the outer edges of the curved intermediate image surface are either formed optically upstream or optically downstream of the folding mirror FM2.

In preferred embodiments, both intermediate images are formed geometrically close to the pupil mirror PM, for example such that a distance between the outer edge of the pupil mirror and the intermediate image does not exceed the diameter of the pupil mirror PM. This positioning allows placing the off-axis object field and image field relatively close to the respective segments OA1, OA3 of the optical axis which, in turn, allows reducing the maximum object height for which the projection objective must be sufficiently corrected to obtain an image.

Both concave mirrors are arranged "optically remote" from a pupil surface which means that they are arranged outside an optical vicinity of a pupil surface. They may be arranged optically nearer to field surfaces than to pupil surfaces. Preferred positions optically remote from a pupil surface may be characterized by the ray height ratio RHR = CRH / MRH > 1. With other words: The first and third mirrors are in positions where the chief ray height exceeds the marginal ray height. In cases where the pupil mirror is not a concave mirror, all concave mirrors may be in positions where the chief ray height exceeds the marginal ray height.

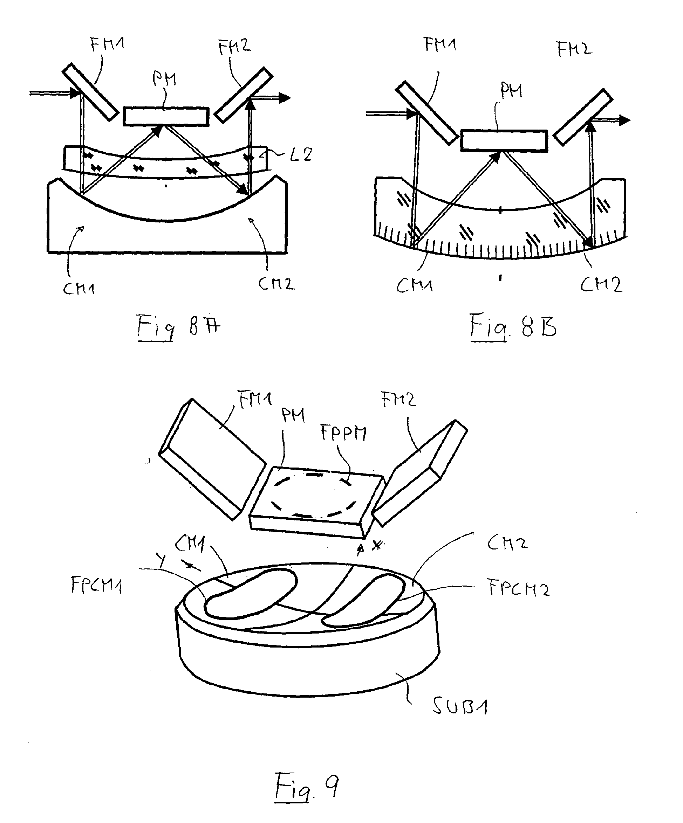

A position "optically remote" from a pupil surface is a position where the cross sectional shape of the radiation beam deviates significantly from the circular shape found in a pupil surface or in an immediate vicinity thereto. The term "radiation beam" as used here describes the bundle of all rays running from the object plane to the image plane. Mirror positions optically remote from a pupil surface may be defined as positions where the beam diameters of the radiation beam in mutually perpendicular directions orthogonal to the propagation direction of the radiation beam deviate by more than 50% or 100% from each other. In other words, illuminated areas (footprints) on the concave mirrors may have a shape having a form strongly deviating from a circle and similar to a high aspect ratio rectangle corresponding to a preferred field shape in lithographic projection objectives for wafer scanners (compare Fig. 9).

The second objective part provides two reflections at concave mirror surfaces, thereby contributing strongly to Petzval sum correction. At the same time, the overall dimensions of the second objective part may be kept moderate due to the fact that the concave reflecting surfaces are both optically remote from a pupil surface. Where a concave mirror is optically closer to a field surface (intermediate image surface) than to a pupil surface, the concave mirror may be denoted as "field mirror". Further, an axial distance, measured along the second segment OA2 of the optical axis, between the pupil mirror PM and the vertex of the concave surface defined by the reflecting surfaces of both concave mirrors CM1, CM2 may be kept small such that the concave mirrors may be positioned relatively close to the primary axis of the projection objective defined by the first and third segments of the optical axis perpendicular to object surface and image surface. A mechanically stable mounting of the concave mirrors is thereby facilitated, and the influence of gravity on the long term performance of the projection objective may be kept small. In some embodiments the geometrical distance $D_V$ between the reflecting surface of the pupil mirror and the vertex of the first and/or second concave mirror is close to the focal length $f_{CM}$ of the concave mirror, that means close to half the value of the radius $R_{CM}$ of curvature of the concave mirror. In some embodiments the condition $0.7 < R_{CM}/D_V < 1.3$ holds, where $D_V$ is the vertex distance (i.e. geometrical distance between the pupil mirror and the vertex defined by the concave mirror(s).

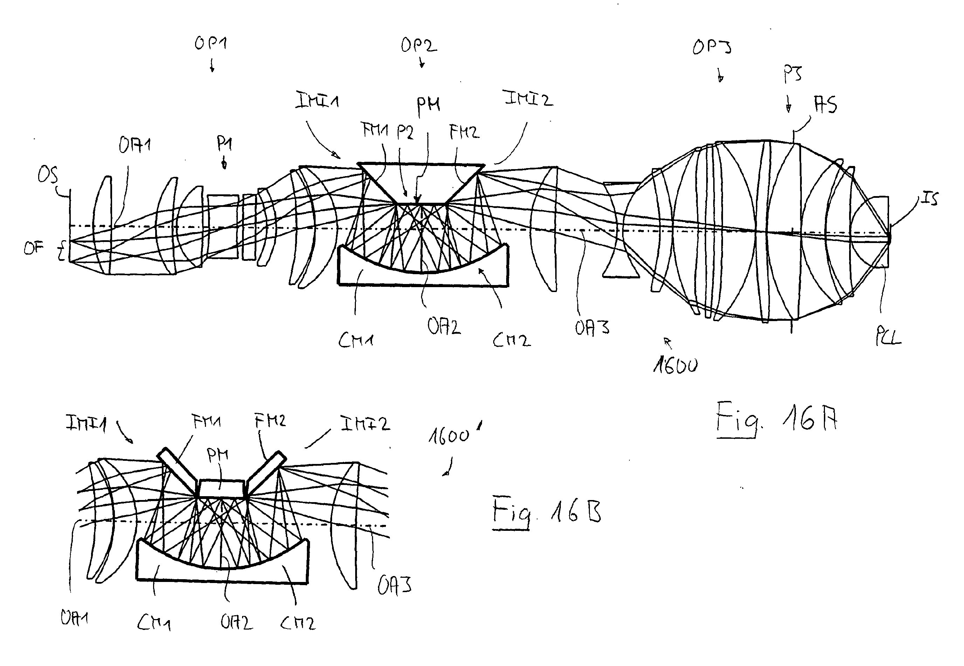

In some embodiments, all ray bundles within the optical system are located within a space defined as a cylinder around an optical axis segment OA3 defined by the third objective part, the cylinder extending from the object surface OS to the image surface and having a radius not exceeding 150% of a maximum ray height within the third objective part. In some cases the radius of the cylinder may be equal to a smaller than this maximum ray height within the objective part (see also e.g. Fig. 16).

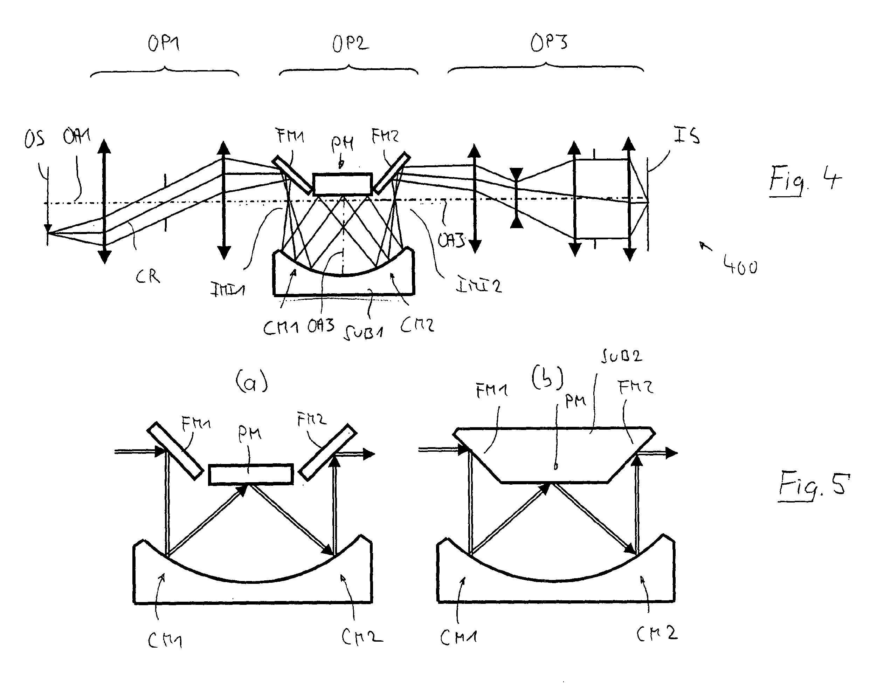

In the embodiment of Fig. 2 the first and second concave mirrors CM1, CM2 are formed on physically separate mirror substrates, which may be mounted in the same mounting structure if desired. Physical separate mirror substrates may be advantageous in order to increase the degrees of freedom for correction means near the field in order to provide better means for correction of field dependent aberrations, such as pupil spherical aberration. In the embodiment of Fig. 4, the first concave mirror CM1 and the second concave mirror CM2 are formed on a common mirror substrate SUB1. With other words: The common mirror substrate SUB1 provides a concave reflecting surface which is used in geometrically separate (non-overlapping), spaced apart reflecting areas forming the first and second concave mirrors CM1, CM2 respectively. The single mirror substrate SUB1 may be mounted in a more stable fashion than the separate mirror substrates, thereby improving a mechanical stability of the overall construction. Further, manufacturing is facilitated since only one test optics may be used to test both reflecting surfaces forming the first and second concave mirrors CM1, CM2.

The number of physically separate optical components within the optical system may further be reduced by forming at least one of the folding mirrors and the pupil mirror on a common substrate having at least two reflecting surfaces oriented at an angle to each other. Fig. 5 shows in (a) the configuration also shown in Fig. 4 having three separate mirror substrates for the first folding mirror FM1, the second folding mirror FM2 and the pupil mirror PM. In the embodiment Fig. 5(b) the first folding mirror FM1, the second folding mirror FM2 and the pupil mirror are formed on a common single mirror substrate SUB2. The mirror substrate SUB2 has a prismatic shape with an substantially isosceles trapezoidal cross-section, where one planar surface forms the planar pupil mirror PM, and adjacent planar surfaces inclined at 45° to the pupil mirror surface form the first and second folding mirrors FM1, FM2. Manufacturing and mounting of reflective components is thereby facilitated and a mechanically stable assembly may be obtained.

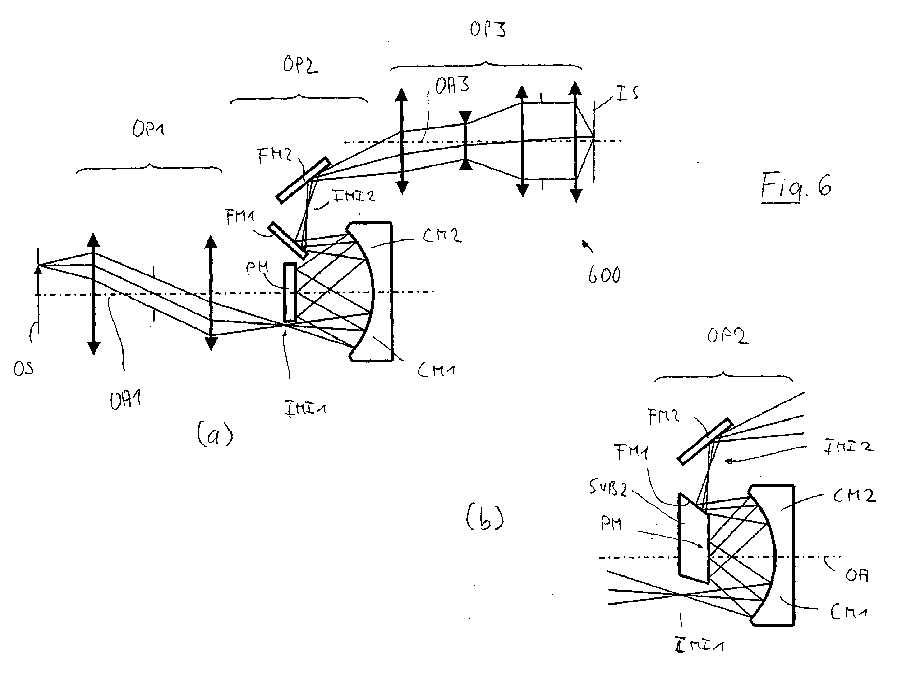

Fig. 6 shows a schematic of an optical system 600 constructed according to a folding variant. In this embodiment, the common axis OA2 of rotational symmetry of the first and second concave mirror CM1, CM2 (i.e. the optical axis segment of the catoptric second objective part) is arranged coaxial with the first segment OA1 of the optical axis defined by the optical components of the first objective part OP1. Planar pupil mirror PM is oriented perpendicular to the optical axis segment OA1 of the first objective part OP1 (parallel to the object surface). The optical axis segment OA1, OA3 defined by the first and third objective part OP1, OP3 respectively are laterally offset to each other by an axis offset exceeding the maximum diameter of optical components within the optical system. Object surface OS and image surface IS are parallel. Radiation from the object surface OS impinges directly (without folding) onto the first concave mirror CM1 after forming the first intermediate image IMI1. Radiation reflected by first concave mirror CM1, pupil mirror PM and second concave mirror CM2 is then incident on first folding mirror FM1 arranged optically downstream of the concave mirrors CM1, CM2. Second folding mirror FM2 is arranged immediately downstream of first folding mirror FM2 with no optical element in between. Second intermediate image IMI2 is formed between the first and second folding mirrors FM1, FM2. On advantage associated with this kind of folding geometry is that the mirror substrate (or mirror substrates) for the first and second concave mirror CM1, CM2 may be mounted symmetrically to the direction of gravity when the projection objective is arranged vertical such that object surface and image surface are oriented horizontally. No optical component with optical power is arranged in a horizontal part of the optical axis subject to asymmetric influence of gravity.

In the variant of Fig. 6(b) the planar pupil mirror PM and the first folding mirror FM1 are formed on a common, prismatic substrate SUB2, whereby manufacturing and mounting is facilitated, and mechanical stability under the influence of gravity may be improved.

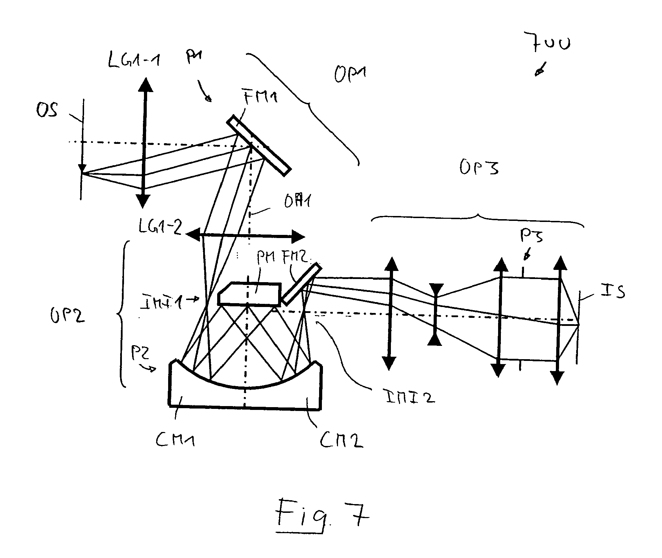

In the embodiment of an optical system 700 in Fig. 7 the first folding mirror FM1 is arranged within the first objective part OP1 between first positive lens group LG1-1 and second positive lens group LG1-2 at or close to the fist pupil surface P1. Therefore, the first segment of the optical axis (OA1), is folded between lenses of the objective part. The construction of second objective part OP2 is similar to that of the embodiment of Fig. 6(b), however, the segment OA2 of the optical axis corresponding to the second objective part is oriented parallel to object surface and image surface instead of perpendicular thereto. Due to the fact that first folding mirror FM1 is arranged at or close to the first pupil surface P1, this embodiment has two mirrors each arranged at or near to a pupil surface, namely first folding mirror FM1 and pupil mirror PM.

In the embodiments discussed above, the second objective part OP2 is purely reflective (catoptric). In other embodiments, the second objective part may include at least one refractive surface, thereby forming a catadioptric second objective part. Figs. 8A and 8B show variants of catadioptric (refractive/reflective) second objective parts. In the embodiment of Fig. 8A a negative meniscus lens L2 is arranged geometrically between the pupil mirror PM and the first and second concave mirrors CM1, CM2 formed on a common mirror substrate. Radiation emerging from first folding mirror FM1 passes the negative lens L2 four times prior to incidence on second folding mirror FM2. In the embodiment of Fig. 8B both the first concave mirror CM1 and the second concave mirror CM2 are designed as a Mangin mirror. Specifically, the Mangin mirror may have a meniscus shaped transparent body having a concave surface (facing the pupil mirror PM when installed) and a spherical convex surface coated with a reflective coating. The reflective coating on the back side of the transparent element forms the first and second concave mirror CM1, CM2. The concave refractive surface of the Mangin mirror is passed four times by radiation between first folding mirror FM1 and second folding mirror FM2. One advantage of providing one or more refractive surfaces adjacent to the concave mirrors is that the mirror surfaces may be formed as spherical surfaces, thereby facilitating manufacturing. The refractive surface of the Mangin mirror, or at least one of the lens surfaces of the free standing lens L2 may be aspherical. The correcting effect of an aspherical surface and/or of a lens surface optically close to the concave mirrors CM1, CM2 (field mirrors) may be used to correct aberrations. Specifically, the spherical aberration of the chief ray of a spherical concave mirror positioned close to a field surface may be corrected.

Fig. 9 demonstrates schematically a characteristic feature of projection objectives having two concave mirrors CM1, CM2 optically remote from the pupil surface, and a pupil mirror PM at or close to a pupil surface.

Fig. 9 shows the "footprints" of the radiation beam passing through the second objective part on the concave reflecting surfaces forming the first and second concave mirror CM1, CM2, respectively, and the pupil mirror PM. As the optical systems generally have a substantially circular pupil centred around the optical axis, the footprint FPPM of the radiation beam on the pupil mirror PM (dashed line) has a substantially circular shape. At the pupil position all ray bundles originating from different field points of the effective object field overlap more or less completely to form the generally circular illuminated area on the pupil mirror. The shape of the footprints is significantly deviating from a circular shape at positions "optically remote" from a pupil surface. In the embodiment, both the first concave mirror CM1 and the second concave mirror CM2, each formed by the same concave reflecting surface on a common substrate SUB1, are optically at positions far away from the pupil surface and optically relative close to the closest intermediate images. For example, the footprint FPCM1 of the radiation beam on the first concave mirror CM 1 is formed by the radiation beam a little way downstream of the first intermediate image IMI1. Depending on the state of correction of the intermediate image, an intermediate image may generally have essentially the same general shape as the effective object field which is imaged onto the intermediate image. Therefore, in the present case with slit-shaped effective object fields having a high aspect ratio between width B perpendicular to the scanning direction and height A parallel to the scanning direction (compare Fig. 14) the cross-sectional shape of the radiation beam close to the intermediate image may resemble the rectangular (or arcuate) slit-shape of the effective object field. For example, the diameters of the footprints in mutually perpendicular directions orthogonal to the propagation direction of the radiation beam may deviate by more than 50% or more than 100% or more than 200% from each other. In the schematic of Fig. 9 it is evident that the footprints FPCM1 and FPCM2 on the first and second concave mirrors CM1, CM2, respectively, are relatively broad in the cross-scan x direction and relatively narrow in the scanning direction (y direction) perpendicular thereto by a factor of two or three or four, for example. Fig. 9 also shows that the footprints on the first and second concave mirrors CM1, CM2 are separate from each other, with a distance therebetween along the y direction. As the footprints FPCM1, FPCM2 do not overlap, it is possible to form the first concave mirror CM! and the second concave mirror CM2 on physically separate mirror substrates if desired (see for example Fig. 2). However, forming both concave mirrors on a common substrate (i.e. on a single physical concave mirror) may be advantageous from a manufacturing and from a stability point of view.

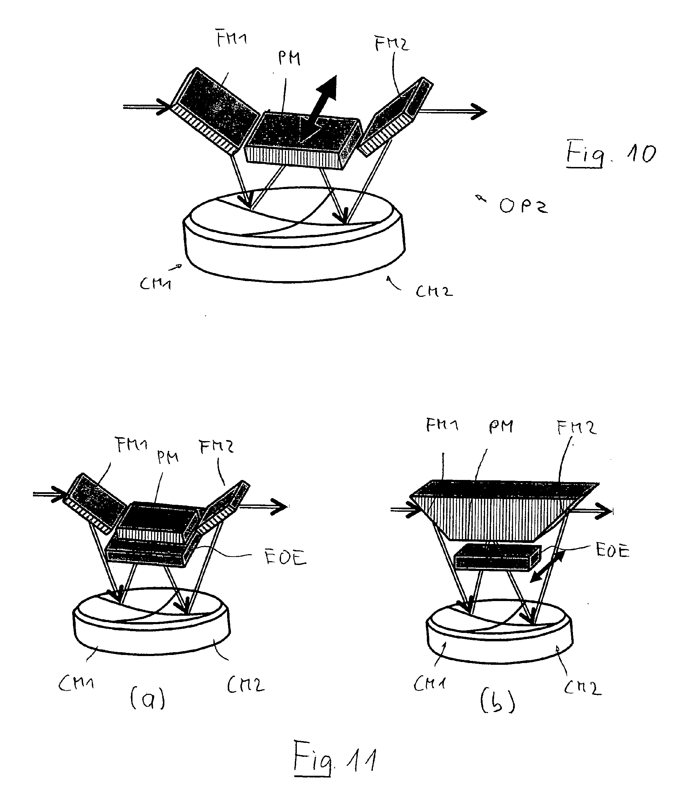

Fig. 10 shows schematically the optical components of the catoptric second objective part OP2 together with separate first and second folding mirrors FM1, FM2, as shown, for example, in Fig. 2, 3, 4, 5(a), 8, 9. In the embodiment of Fig. 10, the pupil mirror PM is constructed as an exchangeable or temporarily removable optical element. With other words: the mounting structure of the pupil mirror PM and the mounting structures of adjacent parts of the optical system are configured to allow removing the pupil mirror from the optical system without disassembling other parts of the optical system, and re-introducing the pupil mirror (or another pupil mirror) in the same mounting position. Where the pupil mirror may be removed and introduced from the optical system it is possible to improve the optical performance of the entire system by applying predefined changes to the shape of the reflective surface of the pupil mirror after assembly of the optical system and adjusting the optical elements to reduce aberrations.

Providing a releasably mounted pupil mirror allows to produce the optical imaging system according to the following method. In a fist step, the optical imaging system is assembled with all the optical elements substantially arranged in the correct positions. Then the optical imaging system is measured to determine the optical performance after the initial assembly. Measuring may be performed with locally resolving determination of the wavefront in the exit pupil or a surface Optically conjugate with the exit pupil to provide data representing wavefront errors in a locally (spatially) resolving manner. Based on these data, a desired shape of the pupil mirror surface (different from the initial shape) may be calculated, the shape of the corrected pupil mirror surface being calculated such that at least part of the wavefront errors is eliminated. In a next step, the pupil mirror may be removed from the optical imaging system. Thereafter, the reflective surface of the pupil mirror may be processed to change the shape of pupil mirror to obtain a desired non-planar surface effective to correct some or all of the residual wavefront errors. Finally, the reconfigured pupil mirror is installed in the previous position within the optical system. A method for reconfiguring a lens surface at or close to a pupil surface of an optical imaging system is disclosed in US 2004/0169836. That method may be modified to reshape the pupil mirror surface. The disclosure of US 2004/0169836 is incorporated herein by reference.

Time-dependent modifications of the optical performance may be obtained in a variety of ways. The optical system may comprise a manipulation device acting on or utilizing at least one optical element positioned near a pupil position in a double pass region passed twice by radiation during operation. In the embodiments of Fig. 11 (a) and 11 (b) an exchangeable optical element EOE is positioned near the second pupil surface directly in front of the pupil mirror PM in a double pass region passed twice by radiation incident on and reflected by the pupil mirror in operation. The exchangeable optical element may be mounted separately from other optical elements such that it may be temporarily removed from the optical path without disassembling other parts of the optical system. The optical performance of the optical system may be improved in a similar way as described in connection with the exchangeable pupil mirror, for example by measuring the performance, calculating a modified shape of at least one of the surfaces of the exchangeable optical element effective to reduce imaging aberrations, reshaping the respective surface to correct aberrations, and remounting the modified exchangeable optical element into its former position. As the corrected refractive surface of the exchangeable optical element is used twice (double pass optical element) relatively minor modifications of the surface shape by removal and/or the deposition of material may have a relatively strong correcting effect.

An optical system may be subject to significant changes of optical properties over the life time of the optical system. For example, varying radiation loads in operation may significantly influence the optical performance. Further, in microlithography there is a tendency to increase the power of the light sources due to the increasing demands on the efficiency of the lithographic manufacturing process. Also, progressively shorter wavelengths are used. Specific illumination settings are employed to optimize the imaging conditions for various pattern types. As a result, various time-dependent changes in the properties of optical materials within the projection system are observed, which may sensibly affect the imaging quality of the exposure system. The heating of lens groups and other transparent optical elements ("lens heating") during operation due to an increased absorption is one effect dynamically influencing the imaging properties. Also, long-term (quasi-static) effects due to radiation induced refractive index variations, such as compaction effects, are observed.

The various time-dependent radiation-induced changes of properties of optical materials within the optical system (such as lens heating, compaction etc.) may induce characteristic imaging aberrations including field-constant contributions to non-spherical aberrations. For example, astigmatism on the axis and four-fold radial symmetric errors (four-waviness) constant over the field are observed. Associated problems may be largely avoided in embodiments comprising a pupil mirror manipulator operatively connected to the pupil mirror and configured to vary the shape of the pupil mirror surface. Providing a pupil mirror having a pupil mirror surface and manipulating means allowing to vary the shape of that reflecting pupil mirror surface allows to compensate for substantially field-constant aberrations such that a wavefront with a low level of field-constant contributions to aberrations may be obtained at the image surface even in the presence of significant disturbances on the wavefront shape due to lens heating, compaction and other time-dependent effects. The correction can generally be obtained by adjusting the shape of the reflecting pupil mirror surface such that a negative contribution of the disturbance caused by lens heating and the like is counteracted by the pupil mirror. As the pupil mirror is positioned close to or at a pupil surface of the projection objective, any deformation or spatially resolved variation of the shape of the reflecting surface has essentially the same effect for all field points, whereby an essentially field-constant correction may be obtained.

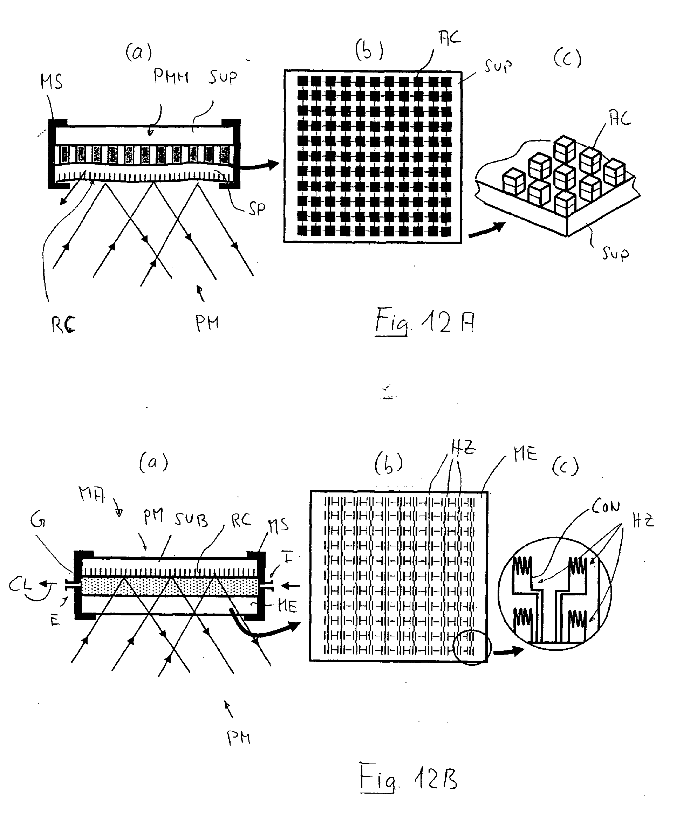

In general, the pupil mirror shape may be altered or changed by applying external forces to the mirror substrate and/or to the mounting structure supporting the mirror substrate. Fig. 12A shows schematically an embodiment of an adaptive pupil mirror where the shape of the reflective surface may be varied continuously in spatially resolving manner. The pupil mirror PM has a substrate plate SP carrying a reflective coating RC on the front side thereof. In the absence of external forces, the substrate plate SP is a plane plate. The substrate plate is held by a rigid mounting structure MS.

A pupil mirror manipulator PMM is provided at the freely accessible backside of the substrate plate. The pupil mirror manipulator includes a rigid support plate SUP mounted within the mounting structure MS, and a plurality of piezoelectric actuators AC arranged between the support plate SUP and the substrate plate SP of the pupil mirror. A large number of electrically controllable actuators AC is arranged in a two-dimensional array configuration, for example in a rectangular matrix configuration as shown schematically in Fig. 12A(b) and (c). In some embodiments a matrix arrangement of 128x128 individual actuators is provided. In general, the number of actuators may be larger or smaller than that, for example one hundred actuators or more, or thousand actuators or more, or ten thousand actuators or more. Although the number of actuators is not limited, in some embodiments there are no more than fifty thousand or no more than twenty thousand actuators. The actuators may be formed as blocks of a piezoelectric material, such as barium titanate, electrically connected independently of other actuators to a pupil mirror control unit. The substrate plate SP carrying the reflective coating is relatively thin and made from an elastically flexible material. In contrast, the support plate SUP is substantially more rigid than the substrate plate SP and may be made from a material having a larger elastic modulus. The length of each of the actuators AC provided between the support plate SUP and the substrate plate SP may be varied in response to electrical signals provided by the pupil mirror control unit such that the local geometry of the reflective surface of the pupil mirror is controllably changed in response to the electrical signals controlling the plurality of actuators AC while, at the same time, the shape of the rigid support plate SUP remains essentially the same.

In general, the mirror arrangement formed by the pupil mirror and the pupil mirror manipulator configured to deform or change the shape of the reflective pupil mirror surface may be constructed as described or in various other ways. Examples are given in US 5,986,795 or applicants patent application US 2006/0018045 A1. The disclosures of these documents is incorporated herein by reference.

Control of a pupil mirror manipulator for effecting a targeted deformation of the reflecting surface of the pupil mirror may be configured in a variety of ways. Various configurations of control circuits incorporated an open-loop control or a closed-loop control and/or model-based control are disclosed in applicant's international patent application PCT/EP2007/007093 filed on August 10, 2007. The corresponding disclosure of this document is incorporated herein by reference.

Fig. 12B shows schematically another variant of an optical arrangement allowing to modify the optical properties of the optical system in the vicinity of the pupil mirror in a time-dependant and spatially resolving manner. Figure 12B (a) shows a mirror arrangement MA including a planar pupil mirror PM formed by a plate-like, rigid mirror substrate SUB having a front side coated with a reflective coating RC. The substrate plate is held by a rigid mounting structure MS. The mounting structure further mounts a plate-like transparent manipulation element ME positioned in front of the pupil mirror at a distance therefrom such that a substantially plane parallel gap G is formed between the reflecting surface of the pupil mirror and the manipulation element. The mounting structure MS includes an input opening I and an exit opening E allowing a cooling liquid CL to be passed through the gap between the plates during operation of the optical system. When the mirror arrangement MA is mounted such that the pupil mirror is at or near a pupil position, the manipulation element is arranged in a double pass region passed twice by radiation on its way to the pupil mirror, and from the pupil mirror, as indicated by arrows in Fig. 12B(a).

In the arrangement of Fig. 12B the pupil mirror is constructed as a Mangin mirror, i.e. a mirror having a medium with a refractive index substantially greater than 1 in front of the reflective surface such that the same refractive index, different from 1, is given upstream and downstream of the reflective surface. In this particular case, the reflective surface is in direct contact with a liquid lens of variable shape and formed by cooling liquid CL.

The transparent manipulation element ME is configured to allow varying the spatial distribution of refractive index in a time-dependent manner in response to electrical signals provided by a control unit (not shown). As shown in Fig. 12B(b) and (c) the transparent manipulation element includes, at least in a central portion used in operation to pass radiation therethrough, a plurality of electrically conducting conductor tracks CON forming a plurality of electrically heatable heating zones HZ distributed over the useful cross-section of the manipulation element in a two-dimensional array configuration. In the embodiment, a rectangular matrix configuration having at least 10 or at least 15 or at least 20 or at least 30 spatially separated heating zones in each direction of a plane parallel to the plate extension (perpendicular to the optical axis in the mounting configuration) are provided. For example, a lateral separation between adjacent heating zones HZ may be less than 30mm or less than 25mm or less than 20mm or less than 15mm or less than 10mm, to provide a high spatial resolution in a temperature profile created by the heating zones. A lateral width of the conducting tracks in the transirradiation direction is typically less than 50 microns or less than 30 microns or smaller in the major portion of the conducting tracks such that radiation passing through the manipulation element suffers only negligible blocking by the conductive tracks. Electric current trough the heating zones may be controlled individually for each heating zone or for specified groups of heating zones to provide a high spatial resolution in a radial direction and/or in azimuthal (circumferential) direction of the manipulation element ME. The network of heating zones allows local heating of the manipulation element at predefined locations and with a predefined amount of heating energy. A predefined spatial distribution of local heating causes a predefined spatial distribution of changes in refractive index and/or changes in the local shape of the manipulation element, whereby the optical properties of the manipulation element may be modified

12

in a spatially resolving manner within short time intervals, for example within some seconds or some minutes. Short-term corrections of wavefront aberrations may thereby be effected in the immediate vicinity of a pupil position such that the corrections may be effective essentially constant for all field points. Various manipulation elements suitable for the described purpose as manipulation element ME are described in applicant's international patent application with publication number WO 2008/034636 A2 . The complete disclosure of this application is incorporated herein by reference.

The fluid channel formed by the gap G between pupil mirror and manipulation element is integral part of a cooling device to actively cool the electrically heatable manipulation element ME. Active cooling prevents the pupil mirror from being heated indirectly by the electric currents passing through the manipulation element. Further, active cooling increases temporal resolution of the changes of refractive index distribution caused by the local heating of the manipulation element. The liquid CL passed through the gap G during operation provides a thermal restoring force counteracting the local heating effected in the regions of the heating zones such that the temporal resolution of the manipulation can further be increased when compared to embodiments without active cooling of the manipulation element.

Control of the electrically controllable manipulation element ME for effecting a targeted deformation and/or refractive index modification may be configured in similar ways as control of the deformation of the reflecting surface of a pupil mirror. Reference is therefore made to applicant's international patent application PCT/EP2007/007093 filed on August 10, 2007, incorporated herein by reference.

A radiation beam passing from the object surface to the image surface is reflected multiple times in the region of the second objective part, thereby increasing the risk that parasitic radiation reaches the image surface, thereby deteriorating the image formation, specifically reducing contrast. The influence of flare on image formation may be reduced in embodiments by providing one or more appropriately positioned baffles preventing stray radiation from reaching the image surface. In the embodiment of Fig. 13, a first baffle B1 is arranged between the first concave mirror CM1 and the second concave mirror CM2 on the common mirror substrate between the reflective areas used by the radiation beam. The first baffle may be formed as a wedge generally extending along the second segment OA2 of the optical axis towards the pupil mirror to ensure that only radiation reflected from the pupil mirror PM reaches the second concave mirror CM2. A second baffle B2 may be provided close to the second intermediate image IMI2 in the manner of the field stop to ensure that only radiation reflected by the second folding mirror FM2, reaches the image surface. A third baffle B3 may be provided near the first intermediate image IMI1 upstream of first folding mirror FM1 to prevent radiation reflected back from the catadioptric second objective part towards the first objective part to reach the image surface indirectly. In general, contrast of image formation may be improved by providing one or more baffles reducing glare in the image surface. Although a combination of two or more baffles may be provided, in some embodiments one baffle may be sufficient.

Embodiments are designed to be used with an off-axis effective object field OF. Fig. 14 shows schematically different field geometries which may be used in some embodiments. In general, a slit-shaped effective object field has a height A parallel to the scanning direction (y-direction) and a width B > A perpendicular to the scanning direction in the cross-scan direction (x-direction). An aspect ratio B/A may be in the range from B/A=2 to B/A=10, for example. Parameter C may be defined as the offset distance between the optical axis OA and the innermost field point of the effective object field OF in the scanning direction (y direction). A circle with minimum radius $R_{DOF}$ around the effective object field and centered about the optical axis OA of the optical system indicates the design object field DOE including field points sufficiently corrected for aberrations to allow imaging for the specified performance and free of vignetting. The effective object field OF includes a subset of those field points. Embodiments may be designed to be used with a rectangular effective object field OF, as schematically shown in Fig. 14(a) and (c). Alternativly, an arcuate effective object field (ring field) as schematically illustrated in Fig. 14(b) may be used. In an arcuate field the longer edges of the effective object field are curved outwardly from the optical axis to define a radius R. An arcuate field shape generally allows to use a larger height A of effective object field at a given width B such that a larger area may be used for the exposure.

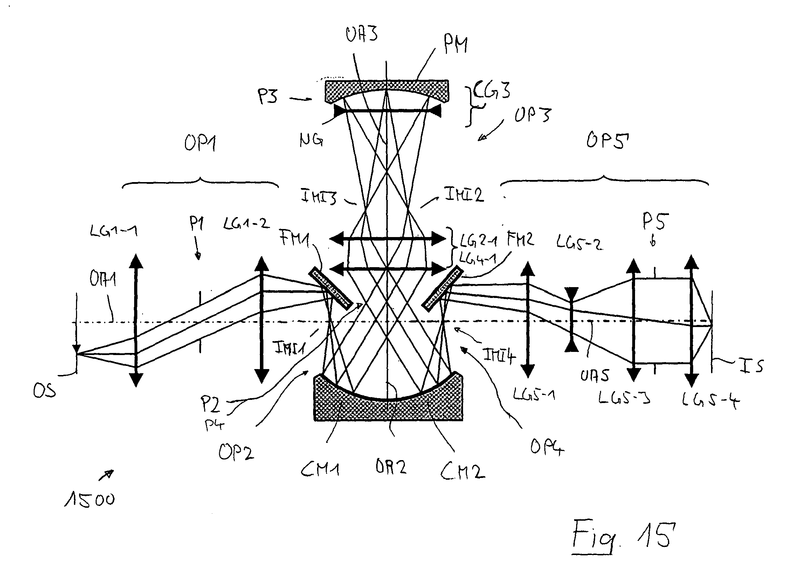

Fig. 15 shows a schematic illustration of a lens section of a catadioptric projection objective 1500 which is designed to project an image of a pattern on a reticle arranged in the planar object surface OS into the planar image surface IS (parallel to the object surface) on a reduced scale while creating exactly four intermediate images IMI1, IMI2, IMI3 and IMI4. A rectangular or arcuate effective object field is used (compare Fig. 14). A first refractive objective part OP1 is configured to image the pattern from the object surface into the first intermediate image IMI1. A second, catadioptric (reflective/refractive) objective part OP2 including the first concave mirror CM1 optically remote from a pupil surface images the first intermediate image IMI1 into the second intermediate image IMI2. A third catadioptric objective part OP3 including a concave pupil mirror PM images the second intermediate image onto a third intermediate image IMI3. A catadioptric fourth objective part OP4 including the second concave mirror CM2 optically remote from a pupil surface images the third intermediate image IMI3 onto the fourth intermediate image IMI4. A refractive fifth objective part OP5 images the fourth intermediate image IMI4 onto the image surface.

A first planar folding mirror FM1 is arranged optically close to the first intermediate image IMI1 at an angle of 45° to the optical axis OA such that it reflects the radiation coming from the object surface in the direction of the first concave mirror CM1. A second folding mirror FM2, having a planar mirror surface aligned at right angles to the planar mirror surface of the first folding mirror, reflects the radiation coming from the second concave mirror CM2 in the direction of the image surface, which is parallel to the object surface.

Five mutually conjugated pupil surfaces P1, P2, P3, P4 and P5 are formed within the respective objective parts. The concave pupil mirror PM is arranged at or close to the third pupil surface P3. Second and fourth pupil surface P2, P4 are geometrically close together between first and second folding mirrors FM1, FM3.

The projection objective may be considered as a derivation of the system shown in Fig. 4, for example, where the planar pupil mirror PM of that embodiment is removed and radiation incident on the second pupil surface is guided through a catadioptric optical system used twice in opposite directions and including a concave pupil mirror PM.

The first objective part OP1 includes first and second positive lens groups LG1-1 and LG1-2 on either side of the first pupil surface P1, and the planar first folding mirror FM1. The second objective part OP2 includes the first concave mirror CM1 optically remote from a pupil surface and a refractive lens group LG2-1, which may have at least one lens optically close to the second pupil surface P2 and at least one lens optically close to the second intermediate image IMI2. The third objective part includes a catadioptric group CG3 formed by the concave pupil mirror PM and a negative lens group NG formed by one or more large negative lenses directly in front of the concave reflecting surface of the concave mirror and passed twice by radiation directed at an reflected from the concave pupil mirror PM. A combination of a concave mirror arranged at or optically close to pupil surface and the negative group comprising at least one negative lens arranged in front of the concave mirror on a reflecting side thereof in a double pass region such that radiation passes at least twice in opposite directions through the negative group is sometimes referred to as "Schupman Achromat". This group contributes significantly to correction of chromatic aberrations, particularly axial chromatic aberration. Correction of Petzval sum is predominantly influenced by the curvature of the concave mirror of the Schupman Achromat.

In some embodiments the third objective part may be purely reflective (catoptric) by omitting the negative group immediately in front of the concave pupil mirror PM.

The fourth objective part OP4 has a similar construction as the second objective part OP2 in so far as it includes a refractive lens group LG4-1 (corresponding to LG2-1) immediately downstream of third intermediate image IMI3, and a concave mirror CM2 optically remote from a pupil surface.

As in the embodiment of Fig. 4, both concave field mirrors CM1, CM2 optically remote from a pupil surface are formed on a common mirror substrate used twice in non-overlapping reflecting areas. As an alternative, first and second concave mirrors CM1, CM2 may be formed on separate mirror substrate, as shown in Fig. 2.

The refractive (dioptric) fifth objective part including the second folding mirror FM2 has a first positive lens group LG5-1, a subsequent negative lens group LG5-2 and a subsequent positive lens group LG5-3 between the fourth intermediate image IMI4 and a fifth pupil surface P5, and a positive lens group LG5-4 between the fifth pupil surface P5 and the image surface. In preferred embodiments the fifth objective part provides the major contribution to overall reduction. For example, the magnification ratio $\beta_5$ of the fifth objective part may obey the condition $-0.15 \leq \beta_5 \leq -0.4$.

The first and second concave mirrors CM1, CM2 optically within the second and fourth objective parts, respectively, have a common axis of rotational symmetry, defining a second optical axis segment OA2 perpendicular to the first and fifth optical axis segments OA1, OA5 defined by the coaxial refractive first and fifth objective parts OP1, OP5. The concave pupil mirror PM in the third objective part OP3 defines a third optical axis segment OA3 coaxial with the second optical axis segment OA2.

The concave mirrors forming the first and second concave mirrors CM1, CM2 optically remote from the pupil surface on one side of the optical axis OA1/OA5 and the concave pupil mirror PM on the opposite side of that optical axis segments limit an intermirror space having a common axis of rotational symmetry parallel to (or at a small angle to) the object surface and image surface. Within this intermirror space, the radiation reflected by the first concave mirror CM1 forms, in this sequence, a first image of the first pupil, an intermediate image (IMI2) a second image of the first pupil (at concave pupil mirror PM), and a further intermediate image (IMI3) prior to the reflection on the second concave mirror CM2. Entry and exit of the radiation beam into and out of the intermirror space is secured by the folding mirrors FM1, FM2 inclined to the optical axis segments.

The following figures illustrate a variety of working examples of projection objectives for microlithography constructed generally in accordance with the principles explained above.

Fig. 16A shows a catadioptric projection objective 1600 designed for a nominal UV operating wavelength $\lambda$=193nm. An image-side numerical aperture NA=1.3 is obtained at a reducing magnification 4:1 ($\beta$=-0.25) in a rectangular off-axis image field with size 26mm* 3mm. C=7mm. The total track length (geometrical distance between object surface OS and image surface IS) is 1411mm. The radius $R_{DOF}$ of the design object field is 65.6mm. The maximum diameter (maximum value of an optically used diameter within the optical system) is 321mm.

The projection objective is an immersion objective adapted to use in immersion lithography using demineralised (pure) water with refractive index $n_{H2O}$=1.43 at 193nm in an image-side working space between the planar exit surface of the projection objective and the image surface in operation. The image-side end of the projection objective is formed by a plano-convex positive lens PCL acting as an immersion lens group ILG to guide the radiation rays from a gas filled space upstream of the convex entry surface of the plano-convex lens into the immersion liquid which fills the image-side working space during operation. All lenses including plano-convex lens PCL are made of fused silica having a refractive index n ≈ 1.56 at λ=193nm. The specification is given in tables 16 and 16A.

The general layout of lens groups and the arrangement of mirrors forming the folding mirrors and the mirrors of the second objective part is the same as described in connection with Fig. 4 (for the lens groups) and Fig. 5(b) for the mirror arrangement. Therefore, reference is made to that description.

The chief ray angle CRA at the pupil mirror PM, measured between the chief ray and the second section OA2 of the optical axis, is about 55° in this embodiment, which is a relatively large value. In an optical imaging system, the product of the paraxial chief ray angle and the size of a pupil is a constant (Lagrange invariant). Therefore, a large chief ray angle at a pupil surface corresponds to a relatively small size of the second pupil, i.e. to relatively small beam diameters of the beam at the second pupil surface. As a consequence, the size (diameter) of the reflecting area of the pupil mirror may be relatively small, which allows the second objective part to have compact dimensions even at very high NA.

It is a characteristic feature of this optical system that the optical elements forming the catoptric second objective part (pupil mirror PM and concave mirrors CM!, CM2 having a common reflective surface formed on a single concave mirror substrate) are positioned relatively close to the main optical axis defined by the first and third objective parts and oriented perpendicular to the object surface and the image surface. The distance of the optical elements from this main optical axis (OA1, OA3) does not exceed the largest semidiameter (i.e. the semidiameter of the largest optical element) in the refractive objective parts (found in the region of the third pupil surface P3 in the third objective part OP3). Considering that in a typical operation condition the object surface and image surface are oriented horizontally and the main optical axis (formed by first and third optical axis segments OA1, OA3) is oriented generally in a vertical direction, the positioning of optical elements close to the vertical optical axis segments provides that the centres of gravity of the optical elements are all near to the vertical optical axis segments, thereby assuring improved mechanical stability when compared to prior art systems having a concave mirror in a generally horizontal side arm of an optical system.

Fig. 16B shows a central section of a variant of the system of Fig. 16A employing two planar folding mirrors FM1, FM2 physically separate from the planar pupil mirror PM, general in accordance with the construction described in connection with Fig. 4. Reference is made to this description. The optical data (specifications) are the same as for the system in Fig. 16A (see tables 16, 16A).

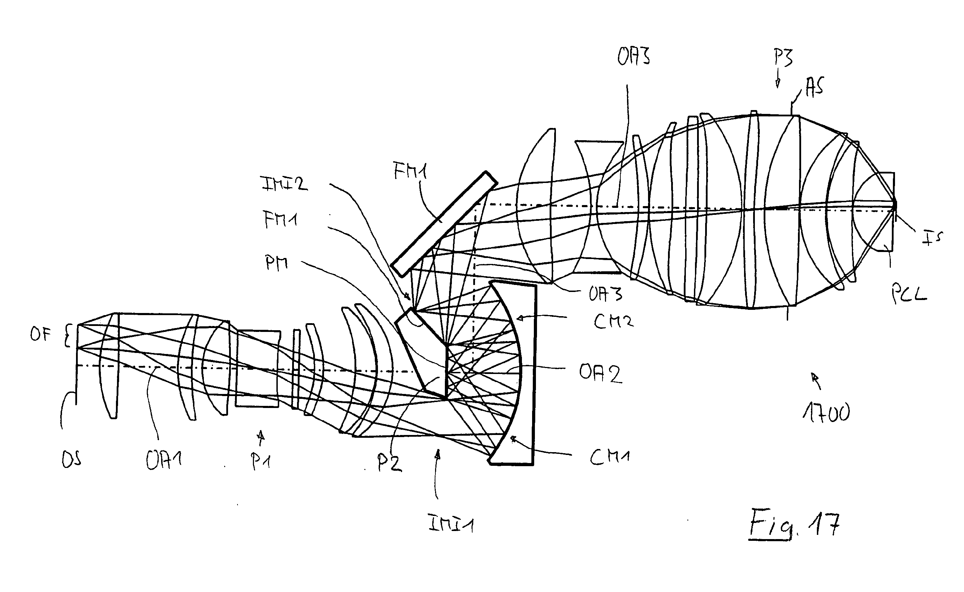

Fig. 17 shows a catadioptric projection objective 1700 constructed generally in accordance with the principles explained in connection with Fig. 6. The pupil mirror PM and the first folding mirror FM1 downstream of the second concave mirror CM2 are formed on a common prismatic substrate SUB2.

An image-side numerical aperture NA=1.3 is obtained at a reducing magnification 4:1 (β=-0.25) in a rectangular off-axis image field with size 26mm . 3mm. C=7mm. The total track length (geometrical distance between object surface OS and image surface IS) is 1310 mm. The radius $R_{DOF}$ of the design object field is 65.6mm. The maximum diameter (maximum value of an optically used diameter within the optical system) is 321 mm. The axis offset between the first segment OA1 of the optical axis the third segment OA3 of the optical axis is 271.4mm. Specifications are given in tables 17, 17A.

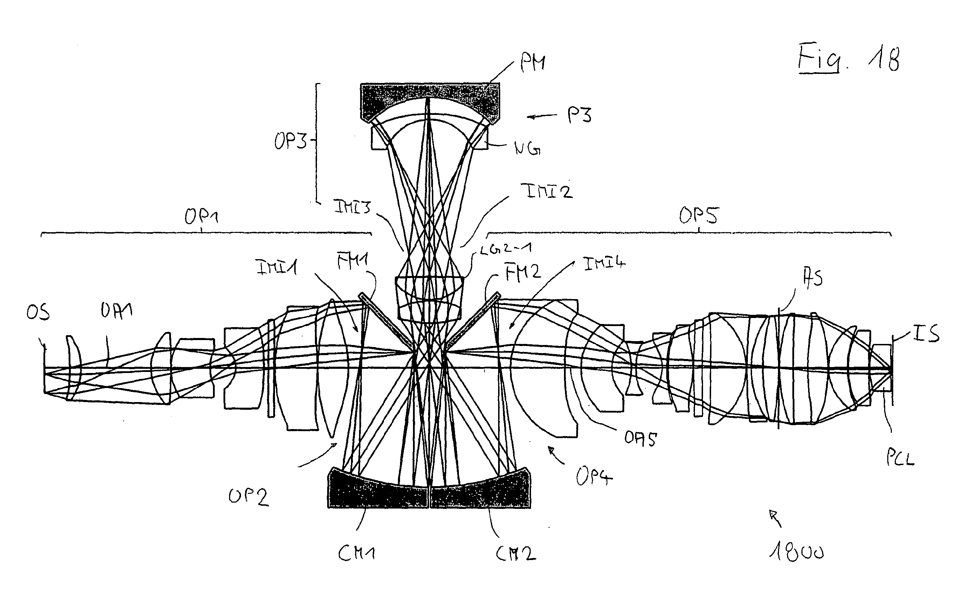

Fig. 18 shows a catadioptric projection objective 1800 constructed generally in accordance with the principles explained in connection with Fig. 15. In this embodiment, a first and second concave mirror CM1, CM2 optically remote from a pupil surface within the second and fourth objective parts OP2, OP4, respectively are formed on separate mirrors substrates. The concave reflecting surfaces have a common axis of rotational symmetry coaxial with the optical axis of concave pupil mirror PM on the opposite side of the first and fifth optical axis segments OA1, OA5. The concave pupil mirror PM is a spherical mirror.

All catadioptric objectives parts, i.e. second objective part OP2, third objective part OP3 and fourth objective part OP4, have a common axis of rotational symmetry inclined by 90 ° relative to the optical axis segments of the refractive objective parts (first objective part and fifth objective part). Considering that the first concave mirror CM1 and the field lens of lens group LG2-1 are both optically remote from a pupil surface and optically very close to an adjacent field surface it is to be noted that at least one intermediate image is created by a catadioptric objective part comprising a mirror and a refractive lens group both remote from a pupil position. In the embodiment, exactly two intermediate images (namely second intermediate image IMI2 and fourth intermediate image IMI4) are created by catadioptric objective parts each comprising a (concave) mirror remote from a pupil position and a refractive lens group remote from a pupil position.

The plano-convex lens PCL forming the immersion lens group ILG directly adjacent to the image surface is made of fused silica. The optical system is adapted to using demineralized water ($n_{H2O}$=1.43 at 193nm) as an immersion liquid to be filled between the immersion lens group and the surface of a substrate arranged in the image surface IS during operation.

The embodiment of Fig. 18 may be characterized by a number of special features. For example, the pupil mirror is a substantially concave mirror. There are two concave mirrors facing each other, one remote from a pupil position and the other near a pupil position. An intermediate image IMI2 is formed optically between the first mirror positioned optically remote from a pupil position and the pupil mirror. An intermediate image IMI3 is formed optically between the pupil mirror and the third mirror positioned optically remote from a pupil position. There are two concave mirrors and two intermediate images (IMI2 and IMI3) between the two concave mirrors. The optical system comprises exactly four intermediate images. A negative group NG having at least one negative lens is arranged immediately in front of the concave pupil mirror in a region passed twice by radiation.

Projection objective 1800 is designed for a nominal UV operating wavelength λ=193nm. An image-side numerical aperture NA=1.05 is obtained at the reducing magnification 4:1 in an arcuate off-axis image field with size A=5mm, B=26mm, C=3.75mm and R=30.5mm. The total track length (geometrical distance between object surface OS and image surface IS) is 1894mm. The radius $R_{DOF}$ of the design object field is 65.6mm. Specifications are given in tables 18, 18A.

There are alternative ways to describe embodiments like that shown in Fig. 18. Consider that the refractive first objective part OP1 and subsequent catadioptric objective part OP2 form an intermediate image (second intermediate image IMI2) from radiation coming from the optical surface. The combination of first and second objective parts OP1, OP2 may be described as a first catadioptric imaging system forming an intermediate image (second intermediate image IMI2) from radiation coming form the object surface, wherein an intermediate image (first intermediate image) is formed within this catadioptric imaging system. Further consider that catadioptric third objective part OP3 in combination with subsequent catadioptric objective part OP4 and refractive objective part OP5 form another catadioptric imaging system which images the intermediate image (second intermediate image IMI2) formed by the first catadioptric imaging system onto the image surface. Alternatively, first, second and third objective part OP1, OP2 and OP3 may be described as a first catadioptric imaging system (including two intermediate images) and forming an intermediate image, which is then imaged onto the image surface by a second catadioptric object imaging system, which is formed by catadioptric fourth objective part OP4 and refractive fifth objective part OP5. In each case, the optical system includes, in this order along the path of radiation, a first mirror CM1 positioned optically remote from a pupil position, a second mirror (concave pupil mirror PM) positioned optically near to a pupil position, and a third mirror CM2 optically remote from a pupil position.

The optical system may also be subdivided into a first catadioptric imaging system (combination of OP1 and OP2) forming an intermediate image (second intermediate image IMI2), a subsequent second catadioptric imaging system (OP3) forming a further intermediate image (third intermediate image IMI3), and a third catadioptric imaging system (combination of OP4 and OP5) forming the final intermediate image. The optical system includes, in this order along the path of radiation, a first mirror CM1 positioned optically remote from a pupil position, a second mirror (concave pupil mirror PM) positioned optically near to a pupil position, and a third mirror CM2 optically remote from a pupil position.

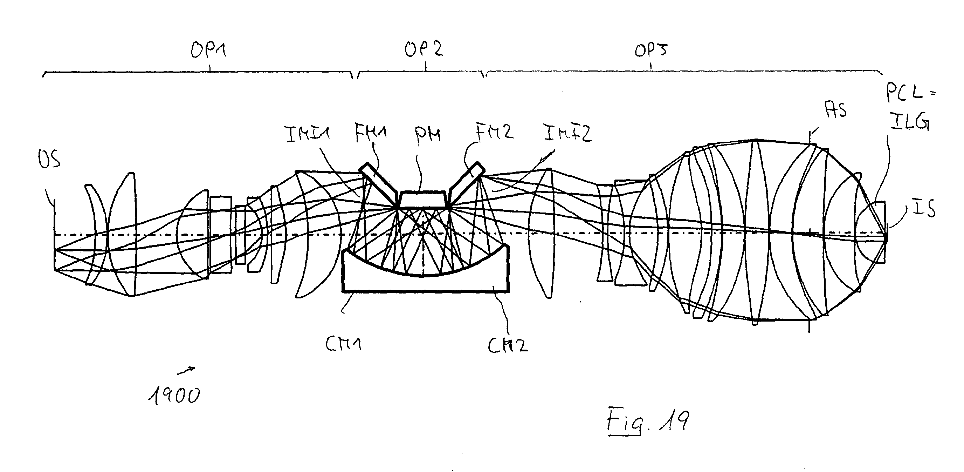

Fig. 19 shows a catadioptric projection objective 1900 constructed generally in accordance with a construction shown in Fig. 16B, for example.

The plano-convex lens PCL forming the immersion lens group ILG directly adjacent to the image surface IS is made of crystalline Barium Lithium Fluoride (BaLiF$_3$) having refractive index $n_{BaLiF}$ = 1.64 at 193 nm. The optical system is adapted to using demineralised water as an immersion liquid.

Projection objective 1900 is designed for a nominal UV operating wavelength λ = 193 nm. An image-side numerical aperture NA = 1.45 is obtained at a reducing magnification 4 : 1 in a rectangular image field with size A = 3 mm, B = 26 mm, C = 6.75 mm. The total track length is 1516 mm. The maximum diameter of an optical element within the system is 341 mm.

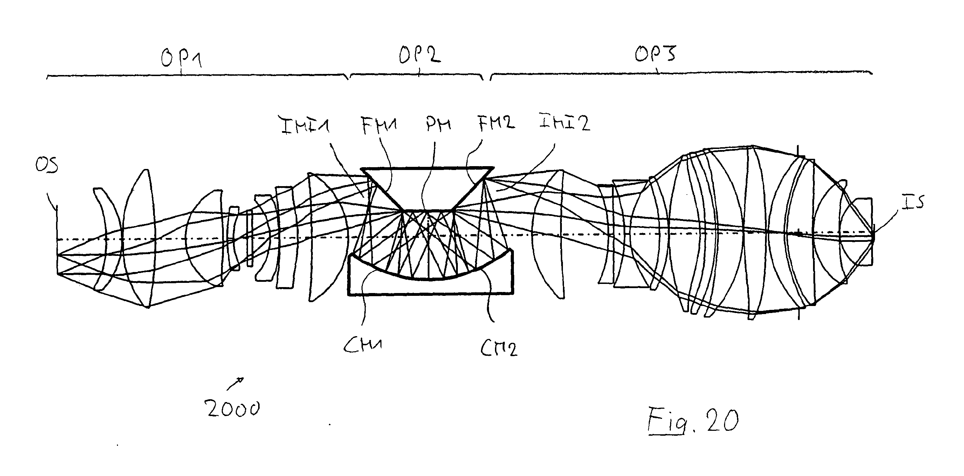

Fig. 20 shows a catadioptric projection objective 2000 constructed generally in accordance with a construction shown in Fig. 16A, for example.

The plano-convex lens PCL forming the immersion lens group ILG directly adjacent to the image surface IS is made of crystalline magnesium aluminium oxide (MgAlO$_4$, spinel) having refractive index $n_{spinel}$ = 1.91 at 193 nm. The optical system is adapted to using demineralised water as an immersion liquid.

Projection objective 2000 is designed for a nominal UV operating wavelength λ = 193 nm. An image-side numerical aperture NA = 1.53 is obtained at a reducing magnification 4 : 1 in a rectangular image field with size A = 2.75 mm, B = 26 mm, C = 7.0 mm. The total track length is 1509 mm. The maximum diameter of an optical element within the system is 325 mm.

Figs. 19 and 20 are two examples for optical imaging systems comprising an immersion lens group having a convex object-side entry surface bounding at a gas or vacuum and an image-side exit surface in contact with an immersion liquid in operation, wherein the immersion lens group is at least partly made of a high-index material with refractive index n ≥ 1.6 at the operating wavelength. In both cases, the immersion lens group is a monolithic plano-convex lens made of the high-index material.

In general, the high-index material may be chosen from the group consisting of aluminum oxide (Al2O3), beryllium oxide (BeO), magnesium aluminum oxide (MgAlO4, spinell), yttrium aluminium oxide (Y$_3$Al$_5$O$_{12}$), yttrium oxide (Y$_2$O$_3$), lanthanum fluoride (LaF$_3$), lutetium aluminium garnet (LuAG), magnesium oxide (MgO), calcium oxide (CaO), lithium barium fluoride (LiBaF$_3$).

Applicant's US-application with publication No. US 2006/0012885 A1 discloses considerations and variants in connection with optical systems having an immersion lens group at least partly made of high-index material. The disclosure of this patent application is incorporated herein by reference.

The above description of the preferred embodiments has been given by way of example. From the disclosure given, those skilled in the art will not only understand the present invention and its attendant advantages, but will also find apparent various changes and modifications to the structures and methods disclosed. It is sought, therefore, to cover all changes and modifications as fall within the spirit and scope of the invention, as defined by the appended claims, and equivalents thereof.

The content of all the claims is made part of this description by reference. Preferred features of the invention:

1. An optical system forming an image of a pattern provided in an object plane of the optical system in an image plane of the optical system, comprising:

a plurality of non-parallel optical axis segments;
a plurality of intermediate images; and
a plurality of mirrors;

wherein radiation emerging from a first intermediate image is incident in this order on a first mirror positioned optically remote from a pupil position, a second mirror positioned optically near to a pupil position to form a pupil mirror, and a third mirror positioned optically remote from a pupil position, prior to forming a second intermediate image.

2. An optical system forming an image of a pattern provided in an object plane of the optical system in an image plane of the optical system, comprising:

a first dioptric imaging system forming an intermediate image and a second catadioptric imaging system forming the final image,
further comprising in this order a first mirror positioned optically remote from a pupil position, a second mirror positioned optically near a pupil position to form a pupil mirror, and a third mirror optically remote from a pupil position.

3. An optical system forming an image of a pattern provided in an object plane of the optical system in an image plane of the optical system, comprising:

a first catadioptric imaging system forming an intermediate image and a second dioptric imaging system forming the final image,
the first catadioptric objective part further comprising in this order a first mirror positioned optically remote from a pupil position, a second mirror positioned optically near a pupil position to form a pupil mirror, and a third mirror optically remote from a pupil position.

4. An optical system forming an image of a pattern provided in an object plane of the optical system in an image plane of the optical system, comprising:

a first dioptric imaging system forming an intermediate image, a second catadioptric or catoptric imaging system forming a second intermediate image, and a third dioptric imaging system forming the final image,
the second catadioptric objective part further comprising in this order a first mirror positioned optically remote from a pupil position, a second mirror positioned optically near a pupil position to form a pupil mirror, and a third mirror optically remote from a pupil position.

5. An optical system forming an image of a pattern provided in an object plane of the optical system in an image plane of the optical system, comprising:

a first catadioptric imaging system forming an intermediate image, and a second catadioptric imaging system forming the final image,
comprising in this order a first mirror positioned optically remote from a pupil position, a second mirror positioned optically near a pupil position to form a pupil mirror, and a third mirror optically remote from a pupil position.

6. An optical system forming an image of a pattern provided in an object plane of the optical system in an image plane of the optical system, comprising:

a first catadioptric imaging system forming an intermediate image and a second catadioptric imaging system forming a further intermediate and a third catadioptric imaging system forming the final image, comprising in this order a first mirror positioned optically remote from a pupil position, a second mirror positioned optically near a pupil position to form a pupil mirror, and a third mirror optically remote from a pupil position.

7. Optical system according to one of clauses 1 to 6, wherein the first mirror positioned optically remote from a pupil position is a first concave mirror, and the third mirror positioned optically remote from a pupil position is a second concave mirror.

8. Optical system according to one of clauses 1 to 6, wherein the first mirror optically remote from the pupil position and the third mirror optically remote from the pupil position are identical in shape and are formed on a single mirror substrate used twice in laterally offset reflecting areas.

9. Optical system according to clause 8, wherein the reflecting areas do not overlap.

10. Optical system according to one of clauses 1 to 6, wherein the first mirror optically remote from the pupil position and the third mirror optically remote from the pupil position are structured as a Mangin mirror.

11. Optical system according to one of clauses 1 to 6, wherein the pupil mirror is a Mangin mirror.

12. Optical system according to one of clauses 1 to 6, wherein the pupil mirror is a substantially planar mirror.

13. Optical system according to one of clauses 1 to 6, wherein the pupil mirror is a concave mirror.

14. Optical system according to one of clauses 1 to 6, wherein an intermediate image is formed optically between the first mirror positioned optically remote from a pupil position and the pupil mirror,

15. Optical system according to one of clauses 1 to 6, wherein an intermediate image is formed optically between the pupil mirror and the third mirror positioned optically remote from a pupil position.

16. Optical system according to one of clauses 1 to 6, wherein the optical system comprises exactly four intermediate images.

17. Optical system according to one of clauses 1 to 6, further comprising a negative group having at least one negative lens immediately in front of the pupil mirror in a region passed twice by radiation.

18. Optical system according to one of clauses 1 to 6, wherein the first intermediate image and the second intermediate image are positioned geometrically near the pupil mirror.

19. Optical system according to one of clauses 1 to 6, wherein the first intermediate image and the second intermediate image are positioned such that a distance between an outer edge of the pupil mirror and the respective intermediate image does not exceed a diameter of the pupil mirror.

20. Optical system according to one of clauses 1 to 6, further comprising at least two planar folding mirrors.

21. Optical system according to clause 20, wherein at least one of the folding mirrors and the pupil mirror are formed on a common substrate having at least two reflecting surfaces.

22. Optical system according to clause 20, wherein the folding mirrors and the pupil mirror are formed on a single mirror substrate reflecting radiation on three different surfaces.

23. Optical system according to clause 20, comprising a first folding mirror and a second folding mirror, wherein there is no refractive surface optically between the first folding mirror and the second folding mirror.

24. Optical system according to one of clauses 1 to 6, comprising a first objective part forming the first intermediate image, a second objective part forming a second intermediate image from the first intermediate image and comprising at least one concave mirror, and a third objective part forming the image in the image plane from the second intermediate image.

25. Optical system according to clause 24, wherein the optical system comprises exactly two intermediate images.

26. Optical system according to one of clauses 1 to 6, wherein the pupil mirror surface is substantially parallel to the object plane or the image plane.

27. Optical system according to one of clauses 1 to 6, wherein the pupil mirror surface is substantially perpendicular to the object plane or the image plane.

28. Optical system according to one of clauses 1 to 6, comprising at least one objective part with at least two non-parallel optical axis segments.

29. Optical system according to one of clauses 1 to 6, comprising two mirrors near a pupil surface position.

30. Optical system according to one of clauses 1 to 6, further comprising an exchangeable optical element positioned near a pupil position in a double pass region passed twice by radiation in operation.

31. Optical system according to clause 30, wherein the exchangeable optical element is positioned in front of the pupil mirror.

32. Optical system according to one of clauses 1 to 6, wherein the pupil mirror is removably mounted such that the pupil mirror can be extracted from the optical system without disassembling other parts of the optical system.

33. Optical system according to one of clauses 1 to 6, further comprising a pupil mirror manipulator operatively connected to the pupil mirror and configured to vary the shape of the pupil mirror surface.

34. Optical system according to one of clauses 1 to 6, further comprising a transparent manipulation element configured to vary a spatial distribution of refractive index in a time-dependent manner in response to electrical signals provided by a control unit.

35. Optical system according to clause 34, wherein the transparent manipulation element includes a plurality of electrically conducting conductor tracks forming a plurality of electrically heatable heating zones distributed over a useful cross-section of the manipulation element in a two-dimensional array configuration.

36. Optical system according to clause 34, wherein the transparent manipulation element is positioned in front of the pupil mirror in a double pass region passed twice by radiation on its way to the pupil mirror, and from the pupil mirror.

37. Optical system according to clause 35, wherein a lateral separation between adjacent heating zones is less than 30mm

38. Optical system according to clause 35, wherein a lateral width of the conducting tracks in a transirradiation direction is less than 50 microns in a major portion of the conducting tracks.

39. Optical system according to clause 35, further comprising a cooling device configured to actively cool the electrically heatable manipulation element.

40. Optical system according to one of clauses 1 to 6, comprising an immersion lens group having a convex object-side entry surface bounding at a gas or vacuum and an image-side exit surface in contact with an immersion liquid in operation, wherein the immersion lens group is at least partly made of a high-index material with refractive index $n \geq 1.6$ at the operating wavelength.

41. Optical system according to clause 40, wherein the immersion lens group is a monolithic plano-convex lens made of the high-index material.

42. Optical system according to clause 40, wherein the high-index material is chosen from the group consisting of aluminum oxide ($Al_2O_3$), beryllium oxide (BeO), magnesium aluminum oxide ($MgAlO_4$, spinell), yttrium aluminium oxide ($Y_3Al_5O_{12}$), yttrium oxide ($Y_2O_3$), lanthanum fluoride ($LaF_3$), lutetium aluminium garnet (LuAG), magnesium oxide (MgO), calcium oxide (CaO), lithium barium fluoride ($LiBaF_3$).

43. Optical system according to one of clauses 1 to 6, wherein the projection objective has an image-side numerical aperture NA $\geq$1.35.

44. A catadioptric optical system comprising:

a plurality of optical elements arranged along a folded optical axis to image a pattern from an object field in an object surface of the optical system to an image field in an image surface region of the optical system at an image-side numerical aperture NA with electromagnetic radiation defining an operating wavelength $\lambda$, including:

a first objective part configured to image the pattern from the object surface into a first intermediate image, and having a first pupil surface;
a second objective part configured to image the first intermediate image into a second intermediate image, and having a second pupil surface optically conjugate to the first pupil surface;
a third objective part configured to image the second intermediate image into the image surface, and having a third pupil surface optically conjugate to the first and second pupil surface;

wherein the second objective part includes
a concave first mirror positioned optically remote from a pupil surface, a second mirror positioned optically near to the second pupil surface to form a pupil mirror, and a convace third mirror positioned optically remote from a pupil surface.

45. Optical system according to clause 44, wherein all concave mirrors are arranged optically remote from a pupil surface at a position where a chief ray height exceeds a marginal ray height of the imaging process.

46. Optical system according to clause 44, wherein there are exactly two concave mirrors and exactly two intermediate images.

47. Optical system according to clause 44, wherein the first objective part is purely refractive, the second objective part is catoptric or catadioptric, and the third objective part is purely refractive.

48. Optical system according to clause 44, wherein the projection objective includes no convex mirror.

49. Optical system according to clause 44, wherein the projection objective is an unobscured system having no pupil obscuration.

50. Optical system according to clause 44, wherein the first objective part is designed as an imaging system having a magnification $\beta_1$ in the range 0.8 $\leq|\beta_1|$ $\leq$1.2.

51. Optical system according to clause 44, wherein the second objective part is designed as near unit magnification optical system.

52. Optical system according to clause 44, wherein the second objective part is designed as a system having a magnification $\beta_2$ in the range 0.9 $\leq|\beta_2|$ $\leq$1.1.

53. Optical system according to clause 44, wherein the third objective part has a reducing magnification $\beta_3$ wherein $|\beta_3| < 1$.

54. Optical system according to clause 44, wherein the third objective part is designed as a system having a magnification $\beta_3$ in the range 0.15 $\leq|\beta_3|$ $\leq$0.4

55. Optical system according to clause 44, wherein curvature surfaces of the concave first mirror and the concave third mirror have a common axis of rotational symmetry inclined at an angle to an object side segment and an image side segment of the optical axis.

56. Optical system according to clause 44, wherein at least one of the concave first mirror and the concave third mirror is designed as a Mangin Mirror.

57. Optical system according to clause 44, wherein all ray bundles within the optical system are located within a space defined as a cylinder around an optical axis segment defined by the third objective part, the cylinder extending from the object surface to the image surface and having a maximum radius of the 1.5 fold of a maximum ray height within the third objective part.

58. Optical system according to clause 44, wherein a radius of the cylinder is equal to or smaller than a maximum ray height within the third objective part.

59. Optical system according to clause 44, wherein a geometrical vertex distance $D_V$ between a reflecting surface of the pupil mirror and the vertex of the first and second concave mirror is close to a focal length $f_{CM}$ of the concave mirror such that the condition $0.7 < R_{CM}/D_V < 1.3$ holds, where $R_{CM}$ is the radius of curvature of the concave mirror.

60. Optical system according to clause 44, wherein the optical system is configured such that radiation reflected from the concave first mirror crosses an optical axis segment of the second objective part prior to impinging on the concave third mirror.

61. Optical system according to clause 44, wherein the concave first mirror and the concave third mirror are disposed on the same side of an optical axis segment defined by the third objective part, and at opposite sides of an optical axis segment of the second objective part.

62. Optical system according to clause 44, wherein the optical system has an image side numerical aperture NA > 0.9.

63. Optical system according to clause 44, wherein the optical system is designed as an immersion optical system adapted with reference to aberrations such that an image side working distance between a last optical element and the image plane is filled up with an immersion medium with a refractive index substantially greater than 1.

64. Optical system according to clause 44, wherein the optical system has an image side numerical aperture NA > 1.1 when used in connection with an immersion medium.

65. Optical system according to clause 44, wherein the optical system is telecentric on both its object end and image end.

66. Optical system according to clause 44, wherein the optical system is configured for use with ultraviolet light falling within a wavelength range extending from about 120 nm to about 260 nm.

67. Optical system according to clause 44, wherein the optical system is a catadioptric projection objective for microlithography.

68. Optical system according to clause 44, further comprising a transparent manipulation element configured to vary a spatial distribution of refractive index in a time-dependent manner in response to electrical signals provided by a control unit.

69. Optical system according to clause 68, wherein the transparent manipulation element includes a plurality of electrically conducting conductor tracks forming a plurality of electrically heatable heating zones distributed over a useful cross-section of the manipulation element in a two-dimensional array configuration.

70. Optical system according to clause 68, wherein the transparent manipulation element is positioned in front of the pupil mirror in a double pass region passed twice by radiation on its way to the pupil mirror, and from the pupil mirror.

71. Optical system according to clause 69, wherein a lateral separation between adjacent heating zones is less than 30mm

72. Optical system according to clause 69, wherein a lateral width of the conducting tracks in the transirradiation direction is less than 50 microns in a major portion of the conducting tracks.

73. Optical system according to clause 69, further comprising a cooling device configured to actively cool the electrically heatable manipulation element.

74. An optical system forming an image of a pattern provided in an object plane of the optical system in an image plane of the optical system, comprising:

> a plurality of non-parallel optical axis segments;
> a plurality of intermediate images; and
> a plurality of mirrors;

wherein all ray bundles within the optical system are located within a space defined as a cylinder around an optical axis segment defined by a final objective part closest to the image plane, the cylinder extending from the object surface to the image surface and having a maximum radius of the 1.5 fold of a maximum ray height within the final objective part.

75. Optical system according to clause 74, further comprising at least two planar folding mirrors inclined relative to optical axis segments to fold an optical axis between adjacent non-parallel optical axis segments.

76. Optical system according to clause 74, further comprising a mirror positioned optically near to a pupil position to form a pupil mirror.

77. Optical system according to clause 74, wherein the object plane and the image plane are oriented in parallel.

78. A catadioptric optical system comprising:

> a plurality of optical elements arranged to image a pattern from an object field in an object surface of the optical system to an image field in an image surface region of the optical system at an image-side numerical aperture NA with electromagnetic radiation defining an operating wavelength λ, including:

>> a first objective part configured to image the pattern from the object surface into a first intermediate image, and having a first pupil surface;
>> a second objective part configured to image the first intermediate image into a second intermediate image, and having a second pupil surface optically conjugate to the first pupil surface;
>> a third objective part configured to image the second intermediate image into the image surface, and having a third pupil surface optically conjugate to the first and second pupil surface;

> wherein the second objective part includes
> a first mirror positioned optically remote from the second pupil surface, a second mirror positioned optically near to the second pupil surface to form a pupil mirror, and a third mirror positioned optically remote from a pupil position.

79. A projection exposure apparatus comprising:

> a light source generating primary radiation;
> an illumination system forming the primary radiation to generate illumination radiation incident on a mask bearing a pattern;
> an optical system according one of clauses 1 to 6 or 44 or 74 or 78 projecting an image of the pattern onto a radiation-sensitive substrate.

The following tables summarize specifications of embodiments described above. In the tables, column 1 specifies the number of a refractive surface or a reflective surface or a surface distinguished in some other way, column 2 specifies the radius r (radius of curvature) of the surface (in mm), column 3 specifies the distance d - also denoted as thickness - between the surface and the subsequent surface (in mm), and column 4 specifies the material of the optical components. Column 5 indicates the refractive index of the material, and column 6 specifies the optically free radius or the optically free semidiameter (or the lens height) of a lens surface or other surfaces (in mm). Radius r=0 corresponds to a planar surface. Aspherical surfaces are indicated by "AS"

The table or tables are designated by the same numbers as the respective figures. A table with additional designation "A" specifies the corresponding aspheric or other relevant data. The aspheric surfaces are calculated according to the following specification:

$$p(h)=[((1/r)h^2)/(1+SQRT(1-(1+K)(1/r)^2h^2))]+C1*h^4+C2*h^6+..$$

In this case, the reciprocal (1/r) of the radius specifies the surface curvature and h specifies the distance between a surface point and the optical axis (i.e. the ray height). Consequently, p(h) specifies the so-called sagitta, that is to say the distance between the surface point and the surface vertex in the z direction (direction of the optical axis). Constant K is the conic constant, and parameters, C1, C2 are aspheric constants.

**Table 16**

| λ=193 nm, NA=1.3, A=3 mm, B= 26 mm und C=7 | | | | | | |
|---|---|---|---|---|---|---|
| Surface | Radius | | Thickness | Material | Index at 193.368 nm | Semidiameter |
| 0 | 0.000000 | | 29.999023 | AIR | 1.00000000 | 65.605 |
| 1 | 0.000000 | | 10.944185 | AIR | 1.00000000 | 75.974 |
| 2 | 192.783405 | AS | 32.089953 | SIO2V190 | 1.56082901 | 87.054 |
| 3 | -1922.214089 | | 77.322390 | AIR | 1.00000000 | 87.143 |
| 4 | 146.088564 | AS | 29.390170 | SIO2V190 | 1.56082901 | 86.055 |
| 5 | 466.370407 | | 7.001994 | AIR | 1.00000000 | 83.583 |
| 6 | 91.492424 | | 45.676551 | SIO2V190 | 1.56082901 | 72.170 |
| 7 | -630.116993 | AS | 10.943578 | AIR | 1.00000000 | 66.733 |
| 8 | -514.388331 | | 48.761549 | SIO2V190 | 1.56082901 | 56.045 |
| 9 | -3656.045862 | AS | 6.371082 | AIR | 1.00000000 | 44.343 |
| 10 | 0.000000 | | 0.000000 | AIR | 1.00000000 | 47.101 |
| 11 | 0.000000 | | 4.197692 | AIR | 1.00000000 | 47.101 |
| 12 | 0.000000 | | 22.087598 | SIO2V190 | 1.56082901 | 49.860 |
| 13 | 0.000000 | | 19.572864 | AIR | 1.00000000 | 58.163 |
| 14 | -128.392339 | | 16.949417 | SIO2V190 | 1.56082901 | 60.922 |
| 15 | -128.774168 | AS | 35.815568 | AIR | 1.00000000 | 69.351 |
| 16 | -393.655345 | | 31.757079 | SIO2V190 | 1.56082901 | 96.477 |
| 17 | -158.198900 | AS | 0.899272 | AIR | 1.00000000 | 100.841 |
| 18 | -197.281000 | | 39.224943 | SIO2V190 | 1.56082901 | 103.246 |
| 19 | -126.661777 | | 147.963428 | AIR | 1.00000000 | 107.327 |
| 20 | 0.000000 | | -78.621624 | REFL | 1.00000000 | 149.422 |
| 21 | 208.230253 | AS | 121.621624 | REFL | 1.00000000 | 140.547 |
| 22 | 0.000000 | | -121.621624 | REFL | 1.00000000 | 41.847 |
| 23 | 208.230253 | AS | 80.121624 | REFL | 1.00000000 | 142.075 |
| 24 | 0.000000 | | -191.461516 | REFL | 1.00000000 | 147.795 |
| 25 | 0.000000 | | -0.896128 | AIR | 1.00000000 | 106.530 |
| 26 | -174.593854 | | -43.850300 | SIO2V190 | 1.56082901 | 109.062 |
| 27 | -1226.115882 | AS | -109.284319 | AIR | 1.00000000 | 107.044 |
| 28 | 140.336790 | | -9.998530 | SIO2V190 | 1.56082901 | 79.722 |
| 29 | -101.400664 | AS | -65.605421 | AIR | 1.00000000 | 84.037 |

(continued)

| λ=193 nm, NA=1.3, A=3 mm, B= 26 mm und C=7 | | | | | |
|---|---|---|---|---|---|
| Surface | Radius | | Thickness | Material | Index at 193.368 nm | Semidiameter |
| 30 | 293.389592 | AS | -22.339214 | SIO2V190 | 1.56082901 | 100.215 |
| 31 | 281.646932 | | -0.982160 | AIR | 1.00000000 | 108.142 |
| 32 | -287.082153 | | -44.329771 | SIO2V190 | 1.56082901 | 145.781 |
| 33 | 447.377528 | AS | -12.728069 | AIR | 1.00000000 | 146.379 |
| 34 | -817.384730 | AS | -15.820679 | SIO2V190 | 1.56082901 | 150.272 |
| 35 | 2119.261353 | | -13.484247 | AIR | 1.00000000 | 152.224 |
| 36 | 9272.339663 | AS | -58.247988 | SIO2V190 | 1.56082901 | 153.945 |
| 37 | 228.242202 | | -0.895254 | AIR | 1.00000000 | 156.955 |
| 38 | -973.145058 | | -18.101270 | SIO2V190 | 1.56082901 | 160.001 |
| 39 | -713.143978 | AS | -45.132578 | AIR | 1.00000000 | 159.691 |
| 40 | 0.000000 | | 0.000000 | AIR | 1.00000000 | 154.429 |
| 41 | 0.000000 | | 44.191463 | AIR | 1.00000000 | 154.429 |
| 42 | -277.118718 | | -59.017861 | SIO2V190 | 1.56082901 | 154.423 |
| 43 | 6400.824557 | AS | -0.887926 | AIR | 1.00000000 | 152.323 |
| 44 | -160.414362 | | -41.792793 | SIO2V190 | 1.56082901 | 127.095 |
| 45 | -262.270291 | | -0.872677 | AIR | 1.00000000 | 121.301 |
| 46 | -182.843806 | | -42.216390 | SIO2V190 | 1.56082901 | 113.595 |
| 47 | 14715.592112 | AS | -0.888987 | AIR | 1.00000000 | 106.895 |
| 48 | -68.827706 | | -65.375550 | SIO2V190 | 1.56082901 | 62.864 |
| 49 | 0.000000 | | -4.274244 | H2OV193B | 1.43662694 | 25.605 |
| 50 | 0.000000 | | | | | 16.402 |

**Table 16A**

| Aspherical Constants | | | | | |
|---|---|---|---|---|---|
| SRF | 2 | 4 | 7 | 9 | 15 |
| K | 0 | 0 | 0 | 0 | 0 |
| C1 | 2.113645e-08 | -3.154709e-08 | 7.296296e-09 | 4.997917e-07 | 7.229626e-08 |
| C2 | -2.738368e-12 | 2.670928e-12 | 3.484933e-11 | 5.771872e-11 | 4.441660e-12 |
| C3 | 1.195216e-16 | 4.131432e-17 | -4.020839e-15 | -1.173564e-15 | -3.637740e-16 |
| C4 | 1.601151e-20 | 6.859779e-21 | 1.304187e-19 | 4.913777e-18 | -1.238583e-19 |
| C5 | -7.877973e-24 | -1.600146e-25 | -1.215494e-22 | 1.142700e-22 | 2.336459e-23 |
| C6 | 1.353395e-27 | 3.155103e-28 | 9.136979e-26 | -1.868438e-24 | -7.920318e-27 |
| C7 | -1.146437e-31 | -1.760096e-32 | -1.988027e-29 | 9.851651e-28 | 1.301435e-30 |
| C8 | 3.890409e-36 | 1.114128e-36 | 1.597502e-33 | -1.596790e-31 | -1.111844e-34 |
| C9 | 0.000000e+00 | 0.000000e+00 | 0.000000e+00 | 0.000000e+00 | 0.000000e+00 |
| | | | | | |
| SRF | 17 | 21 | 23 | 27 | 29 |

(continued)

| Aspherical Constants | | | | | |
|---|---|---|---|---|---|
| SRF | 2 | 4 | 7 | 9 | 15 |
| K | 0 | 0 | 0 | 0 | 0 |
| K | 0 | -1.90513 | -1.90513 | 0 | 0 |
| C1 | 2.435589e-09 | 1.878675e-08 | 1.878675e-08 | 9.553382e-09 | 2.097922e-07 |
| C2 | 3.919298e-13 | -1.047131e-13 | -1.047131e-13 | -3.582873e-14 | 1.656253e-13 |
| C3 | 5.216204e-17 | 1.153569e-18 | 1.153569e-18 | 3.638246e-18 | 1.032708e-15 |
| C4 | 8.916589e-22 | 5.835398e-23 | 5.835398e-23 | 1.992645e-22 | 1.171638e-20 |
| C5 | 4.404959e-25 | -5.913637e-27 | -5.913637e-27 | 1.798149e-27 | -2.119578e-23 |
| C6 | -4.749323e-29 | 2.859270e-31 | 2.859270e-31 | -1.640753e-30 | 6.239495e-27 |
| C7 | 3.378107e-33 | -7.554712e-36 | -7.554712e-36 | 4.488042e-35 | -7.044130e-31 |
| C8 | -9.989789e-38 | 8.585939e-41 | 8.585939e-41 | 5.212174e-40 | 3.522941e-35 |
| C9 | 0.000000e+00 | 0.000000e+00 | 0.000000e+00 | 0.000000e+00 | 0.000000e+00 |
| | | | | | |
| SRF | 30 | 33 | 34 | 36 | 39 |
| K | 0 | 0 | 0 | 0 | 0 |
| C1 | -4.007399e-08 | -8.012430e-08 | 4.936722e-08 | 6.785835e-09 | 2.905115e-08 |
| C2 | 8.706743e-13 | 1.137099e-12 | -5.692230e-13 | 8.709381e-13 | -9.375919e-13 |
| C3 | 5.730812e-17 | 1.589138e-17 | 1.459938e-17 | -7.291265e-17 | 4.051213e-17 |
| C4 | -8.563296e-21 | -3.089958e-21 | -5.175516e-21 | 7.862702e-21 | -3.479834e-22 |
| C5 | 1.350473e-24 | 1.494842e-25 | 2.597195e-25 | -4.316601e-25 | -3.849412e-26 |
| C6 | -2.153881e-28 | -5.886523e-30 | -6.507058e-30 | 1.377976e-29 | 1.855458e-30 |
| C7 | 1.416459e-32 | 1.284798e-34 | 8.862554e-35 | -2.365034e-34 | -3.810827e-35 |
| C8 | -6.674576e-37 | -8.693859e-40 | -2.557005e-40 | 1.259784e-39 | 3.588564e-40 |
| C9 | 0.000000e+00 | 0.000000e+00 | 0.000000e+00 | 0.000000e+00 | 0.000000e+00 |
| | | | | | |
| SRF | 43 | 47 | | | |
| K | 0 | 0 | | | |
| C1 | 4.796564e-09 | -5.028767e-08 | | | |
| C2 | 3.175795e-13 | 2.890394e-13 | | | |
| C3 | -5.990799e-17 | -1.188094e-16 | | | |
| C4 | 4.071553e-21 | 1.289597e-20 | | | |
| C5 | -1.548499e.25 | -6.517250e-25 | | | |
| C6 | 2.737002e-30 | 1.346462e-29 | | | |
| C7 | -7.039783e-36 | 2.511014e-34 | | | |
| C8 | -3.136449e-40 | -1.283489e-38 | | | |
| C9 | 0.000000e+00 | 0.000000e+00 | | | |

**Table 17**

| Surface | Radius | | Thickness | Material | Index at 193.368 nm | Semidiameter |
|---|---|---|---|---|---|---|
| λ=193 nm, NA=1.3, A=3 mm, B= 26 mm und C=7 | | | | | | |
| 0 | 0.000000 | | 29.999023 | AIR | 1.00000000 | 65.605 |
| 1 | 0.000000 | | 7.594554 | AIR | 1.00000000 | 75.986 |
| 2 | 194.634531 | AS | 30.586666 | SIO2V190 | 1.56082901 | 85.598 |
| 3 | -2618.337221 | | 96.597606 | AIR | 1.00000000 | 85.718 |
| 4 | 162.814460 | AS | 22.495752 | SIO2V190 | 1.56082901 | 86.011 |
| 5 | 387.499115 | | 17.146211 | AIR | 1.00000000 | 84.255 |
| 6 | 103.576976 | | 45.864599 | SIO2V190 | 1.56082901 | 76.727 |
| 7 | -482.734251 | AS | 11.285708 | AIR | 1.00000000 | 72.573 |
| 8 | -3121.473268 | | 66.999660 | SIO2V190 | 1.56082901 | 61.766 |
| 9 | -2223.239244 | AS | 12.351980 | AIR | 1.00000000 | 50.639 |
| 10 | 0.000000 | | 0.000000 | AIR | 1.00000000 | 55.159 |
| 11 | 0.000000 | | 12.758094 | AIR | 1.00000000 | 55.159 |
| 12 | 0.000000 | | 9.999437 | SIO2V190 | 1.56082901 | 61.200 |
| 13 | 0.000000 | | 25.282740 | AIR | 1.00000000 | 64.051 |
| 14 | -164.812100 | | 14.585226 | SIO2V190 | 1.56082901 | 68.881 |
| 15 | -142.158384 | AS | 52.601976 | AIR | 1.00000000 | 74.518 |
| 16 | -209.948980 | | 34.447067 | SIO2V190 | 1.56082901 | 97.564 |
| 17 | -130.629422 | AS | 0.898632 | AIR | 1.00000000 | 102.136 |
| 18 | -163.114932 | | 25.886516 | SIO2V190 | 1.56082901 | 104.510 |
| 19 | -134.045348 | | 89.971200 | AIR | 1.00000000 | 108.088 |
| 20 | 0.000000 | | 121.144816 | AIR | 1.00000000 | 118.331 |
| 21 | -209.053692 | AS | -121.144816 | REFL | 1.00000000 | 142.236 |
| 22 | 0.000000 | | 121.144816 | REFL | 1.00000000 | 42.601 |
| 23 | -209.053692 | AS | -79.144816 | REFL | 1.00000000 | 141.972 |
| 24 | 0.000000 | | 271.430950 | REFL | 1.00000000 | 117.608 |
| 25 | 0.000000 | | -67.895501 | REFL | 1.00000000 | 120.366 |
| 26 | -176.503654 | | -56.037993 | SIO2V190 | 1.56082901 | 125.071 |
| 27 | -704.218012 | AS | -66.793425 | AIR | 1.00000000 | 122.554 |
| 28 | 212.966621 | | -9.996577 | SIO2V190 | 1.56082901 | 106.367 |
| 29 | -124.210199 | AS | -69.162668 | AIR | 1.00000000 | 103.487 |
| 30 | 398.340076 | AS | -17.168612 | SIO2V190 | 1.56082901 | 113.036 |
| 31 | 361.352850 | | -0.893916 | AIR | 1.00000000 | 116.492 |
| 32 | -304.410311 | | -37.977377 | SIO2V190 | 1.56082901 | 138.354 |
| 33 | 437.945747 | AS | -21.877643 | AIR | 1.00000000 | 138.671 |
| 34 | -946.199145 | AS | -19.968106 | SIO2V190 | 1.56082901 | 146.663 |
| 35 | 3264.107180 | | -14.350192 | AIR | 1.00000000 | 149.084 |
| 36 | 4923.278050 | AS | -57.641594 | SIO2V190 | 1.56082901 | 150.071 |

(continued)

| Surface | Radius | | Thickness | Material | Index at 193.368 nm | Semidiameter |
|---|---|---|---|---|---|---|
| | λ=193 nm, NA=1.3, A=3 mm, B= 26 mm und C=7 | | | | | |
| 37 | 236.958809 | | -3.722811 | AIR | 1.00000000 | 154.655 |
| 38 | -1531.174068 | | -17.047385 | SIO2V190 | 1.56082901 | 159.955 |
| 39 | -683.768665 | AS | -57.392178 | AIR | 1.00000000 | 160.052 |
| 40 | 0.000000 | | 0.000000 | AIR | 1.00000000 | 153.631 |
| 41 | 0.000000 | | 40.780814 | AIR | 1.00000000 | 153.631 |
| 42 | -285.419395 | | -57.024071 | SIO2V190 | 1.56082901 | 153.706 |
| 43 | -7212.164644 | AS | -0.897666 | AIR | 1.00000000 | 151.833 |
| 44 | -155.598597 | | -42.642221 | SIO2V190 | 1.56082901 | 126.290 |
| 45 | -248.767277 | | -0.986121 | AIR | 1.00000000 | 120.372 |
| 46 | -180.072205 | | -41.710009 | SIO2V190 | 1.56082901 | 113.193 |
| 47 | -2198.545868 | AS | -0.900107 | AIR | 1.00000000 | 106.331 |
| 48 | -69.579156 | | -65.350055 | SIO2V190 | 1.56082901 | 63.254 |
| 49 | 0.000000 | | -4.274244 | H2OV193B | 1.43662694 | 25.638 |
| 50 | | | | | | 16.402 |

**Table 17A**

| | Aspherical Constants | | | | |
|---|---|---|---|---|---|
| SRF | 2 | 4 | 7 | 9 | 15 |
| K | 0 | 0 | 0 | 0 | 0 |
| C1 | 1.511210e-08 | -4.874634e-08 | 1.712807e-09 | 4.238553e-07 | 8.535349e-08 |
| C2 | -1.550573e-12 | 1.396588e-12 | 3.233677e-11 | 3.147796e-11 | 5.523482e-12 |
| C3 | 1.195196e-16 | 1.774457e-16 | -6.950076e-15 | -1.543100e-15 | -6.896434e-17 |
| C4 | -2 717424e-20 | -2.844352e-20 | 2.252845e-18 | 7.220244e-19 | 2.826329e-20 |
| C5 | 5.449931 e-24 | 2.813943e-24 | -7.317663e-22 | 1.075519e-21 | -1.550258e-23 |
| C6 | -6.468359e-28 | 3.987829e-28 | 1.589451e-25 | -7.534576e-25 | 3.161001e-27 |
| C7 | 3.981957e-32 | -1.192820e-31 | -1.865016e-29 | 2.157248e-28 | -3.782757e-31 |
| C8 | -9.951898e-37 | 7.836479e-36 | 9.161857e-34 | -2.242727e-32 | 1.527501e-35 |
| C9 | 0.000000e+00 | 0.000000e+00 | 0.000000e+00 | 0.000000e+00 | 0.000000e+00 |
| | | | | | |
| SRF | 17 | 21 | 23 | 27 | 29 |
| K | 0 | -1.90513 | -1.90513 | 0 | 0 |
| C1 | -1.154256e-09 | -1.864800e-08 | -1.864800e-08 | 2.811487e-08 | 6.553244e-08 |
| C2 | -9.100518e-14 | 9.336249e-14 | 9.336249e-14 | -5.701750e-13 | 3.700080e-12 |
| C3 | -1.748228e-17 | -6.822531e-19 | -6.822531e-19 | 1.795532e-17 | -6.452366e-17 |
| C4 | 5.118239e-21 | -1.291461e-22 | -1.291461e-22 | 2.997339e-21 | 3.581266e-20 |
| C5 | -8.509439e-25 | 1.064540e-26 | 1.064540e-26 | -3.966728e-25 | -7.385347e-24 |
| C6 | 7.845302e-29 | -4.752215e-31 | -4.752215e-31 | 2.839993e-29 | 9.815616e-28 |

(continued)

| Aspherical Constants | | | | | |
|---|---|---|---|---|---|
| SRF | 2 | 4 | 7 | 9 | 15 |
| K | 0 | 0 | 0 | 0 | 0 |
| C7 | -4.313746e-33 | 1.151182e-35 | 1.151182e-35 | -1.030624e-33 | -6.541306e-32 |
| C8 | 9.869803e-38 | -1.190710e-40 | -1.190710e-40 | 1.372383e-38 | 1.897310e-36 |
| C9 | 0.000000e+00 | 0.000000e+00 | 0.000000e+00 | 0.000000e+00 | 0.000000e+00 |
| | | | | | |
| SRF | 30 | 33 | 34 | 36 | 39 |
| K | 0 | 0 | 0 | 0 | 0 |
| C1 | -4.976392e-08 | -8.419648e-08 | 4.934739e-08 | 3.541633e-09 | 3.928664e-08 |
| C2 | 1.040096e-12 | 9.494471e-13 | -6.513939e-13 | 8.778106e-13 | -1.243561e-12 |
| C3 | 1.313686e-16 | 4.994595e-17 | 1.515405e-17 | -6.655536e-17 | 4.408461e-17 |
| C4 | -7.402006e-21 | -5.668449e-21 | -5.281476e-21 | 7.614311e-21 | 3.992999e-22 |
| C5 | 3.515599e-25 | 1.675152e-25 | 2.481391e-25 | -4.136946e-25 | -7.232697e-26 |
| C6 | -6.291308e-29 | -1.105099e-30 | -6.435950e-30 | 1.301968e-29 | 1.690577e-30 |
| C7 | 6.443543e-33 | -1.679873e-34 | 5.416440e-35 | -2.024419e-34 | -6.517730e-37 |
| C8 | -3.179116e-37 | 3.874145e-39 | 8.831451e-40 | 1.056498e-39 | -2.679174e-40 |
| C9 | 0.000000e+00 | 0.000000e+00 | 0.000000e+00 | 0.000000e+00 | 0.000000e+00 |
| | | | | | |
| SRF | 43 | 47 | | | |
| K | 0 | 0 | | | |
| C1 | 1.644987e-08 | -3.624851e-08 | | | |
| C2 | 2.266746e-13 | 1.160722e-12 | | | |
| C3 | -8.766222e-17 | -2.535262e-16 | | | |
| C4 | 5.281119e-21 | 1.426783e-20 | | | |
| C5 | -1.386353e-25 | 3.799655e-25 | | | |
| C6 | 8.588599e-31 | -1.009955e-28 | | | |
| C7 | 2.769917e-35 | 5.786570e-33 | | | |
| C8 | -4.235442e-40 | -1.189402e-37 | | | |
| C9 | 0.000000e+00 | 0.000000e+00 | | | |

**Table 18**

| λ=193 nm, NA=1.05, A=5 mm, B= 26 mm und C=3,75, R=30,5 | | | | | |
|---|---|---|---|---|---|
| Surface | Radius | | Thickness | Material | Index at 193.368 nm | Semidiameter |
| 0 | 0.000000 | | 29.999023 | AIR | 1.00000000 | 57.000 |
| 1 | 0.000000 | | 27.686084 | AIR | 1.00000000 | 65.209 |
| 2 | -632.167745 | AS | 25.751084 | SIO2V190 | 1.56082901 | 71.120 |
| 3 | -127.743416 | | 157.532109 | AIR | 1.00000000 | 73.487 |
| 4 | 109.459310 | AS | 44.572004 | SIO2V190 | 1.56082901 | 81.848 |

(continued)

| Surface | Radius | | Thickness | Material | Index at 193.368 nm | Semidiameter |
|---|---|---|---|---|---|---|
| | | | λ=193 nm, NA=1.05, A=5 mm, B= 26 mm und C=3,75, R=30,5 | | | |
| 5 | -1268.979677 | | 0.906814 | AIR | 1.00000000 | 79.322 |
| 6 | 121.320664 | | 88.316882 | SIO2V190 | 1.56082901 | 66.876 |
| 7 | 90.315363 | AS | 58.018718 | AIR | 1.00000000 | 40.484 |
| 8 | -57.125404 | | 64.087441 | SIO2V190 | 1.56082901 | 46.879 |
| 9 | -684.013774 | AS | 0.907009 | AIR | 1.00000000 | 92.018 |
| 10 | 0.000000 | | 4.212854 | AIR | 1.00000000 | 101.110 |
| 11 | 0.000000 | | 4.197731 | AIR | 1.00000000 | 103.831 |
| 12 | 0.000000 | | 13.888957 | SIO2V190 | 1.56082901 | 106.453 |
| 13 | 0.000000 | | 1.115217 | AIR | 1.00000000 | 110.790 |
| 14 | 305.799807 | | 96.666507 | SIO2V190 | 1.56082901 | 130.409 |
| 15 | -514.286418 | AS | 0.932019 | AIR | 1.00000000 | 140.484 |
| 16 | 417 564664 | | 70.288777 | SIO2V190 | 1.56082901 | 155.576 |
| 17 | -243.742479 | AS | 184.993635 | AIR | 1.00000000 | 156.312 |
| 18 | 0.000000 | | -266.243937 | REFL | 1.00000000 | 170.080 |
| 19 | 545.471089 | AS | 301.243937 | REFL | 1.00000000 | 198.469 |
| 20 | 0.000000 | | 68.409025 | AIR | 1.00000000 | 33.347 |
| 21 | 245.238051 | | 49.357626 | SIO2V190 | 1.56082901 | 64.058 |
| 22 | -167.104372 | | 2.652370 | AIR | 1.00000000 | 69.945 |
| 23 | 100.210974 | | 50.003385 | SIO2V190 | 1.56082901 | 75.833 |
| 24 | -3341.333033 | | 350.813207 | AIR | 1.00000000 | 71.297 |
| 25 | -106.965324 | | 12.552713 | SIO2V190 | 1.56082901 | 98.448 |
| 26 | -326.808210 | AS | 36.446897 | AIR | 1.00000000 | 131.865 |
| 27 | -196.726273 | | -36.446897 | REFL | 1.00000000 | 139.402 |
| 28 | -326.808210 | AS | -12.552713 | SIO2V190 | 1.56082901 | 129.781 |
| 29 | -106.965324 | | -350.813207 | AIR | 1.00000000 | 95.858 |
| 30 | -3341.333033 | | -50.003385 | SIO2V190 | 1.56082901 | 72.182 |
| 31 | 100.210974 | | -2.652370 | AIR | 1.00000000 | 76.596 |
| 32 | -167 104372 | | -49.357626 | SIO2V190 | 1.56082901 | 71.053 |
| 33 | 245.238051 | | -68.409025 | AIR | 1.00000000 | 65.448 |
| 34 | 0.000000 | | -301.243937 | AIR | 1.00000000 | 32.603 |
| 35 | 564.599432 | | 266.243937 | REFL | 1.00000000 | 219.769 |
| 36 | 0.000000 | | -184.990678 | REFL | 1.00000000 | 178.218 |
| 37 | -167.027572 | | -124.764027 | SIO2V190 | 1.56082901 | 155.224 |
| 38 | -926.808245 | AS | -37.254829 | AIR | 1.00000000 | 125.013 |
| 39 | -132.882148 | | -70.205607 | SIO2V190 | 1.56082901 | 98.802 |
| 40 | -88.818284 | | -44.299308 | AIR | 1.00000000 | 63.268 |
| 41 | 140.693981 | | -9.999186 | SIO2V190 | 1.56082901 | 61.024 |

(continued)

| Surface | Radius | | Thickness | Material | Index at 193.368 nm | Semidiameter |
|---|---|---|---|---|---|---|
| | | | | | λ=193 nm, NA=1.05, A=5 mm, B= 26 mm und C=3,75, R=30,5 | |
| 42 | -135.718915 | AS | -59.615416 | AIR | 1.00000000 | 57.126 |
| 43 | 77.860472 | AS | -10.013437 | SIO2V190 | 1.56082901 | 65.641 |
| 44 | -262.615542 | | -2.707677 | AIR | 1.00000000 | 80.372 |
| 45 | -226.769294 | | -56.980156 | SIO2V190 | 1.56082901 | 90.929 |
| 46 | 218.470955 | AS | -1.331803 | AIR | 1.00000000 | 98.659 |
| 47 | -495.428581 | AS | -19.782142 | SIO2V190 | 1.56082901 | 106.169 |
| 48 | -3346.966523 | | -19.356839 | AIR | 1.00000000 | 109.933 |
| 49 | -2968.293203 | AS | -81.699050 | SIO2V190 | 1.56082901 | 119.295 |
| 50 | 146549575 | | -0.899445 | AIR | 1.00000000 | 126284 |
| 51 | -1004.018103 | | -9.999551 | SIO2V190 | 1.56082901 | 120.251 |
| 52 | -200.775533 | AS | -26.503293 | AIR | 1.00000000 | 116.740 |
| 53 | -445.207548 | | -35.875870 | SIO2V190 | 1.56082901 | 118.677 |
| 54 | 475.422633 | AS | 0.301430 | AIR | 1.00000000 | 119.447 |
| 55 | 0.000000 | | 0.000000 | AIR | 1.00000000 | 119.688 |
| 56 | 0.000000 | | -1.297557 | AIR | 1.00000000 | 119.688 |
| 57 | -334.220549 | | -30.785181 | SIO2V190 | 1.56082901 | 124.924 |
| 58 | -2790.657716 | | -33.163022 | AIR | 1.00000000 | 124.795 |
| 59 | -579.009617 | AS | -45.122464 | SIO2V190 | 1.56082901 | 124.842 |
| 60 | 389.059133 | AS | -0.965073 | AIR | 1.00000000 | 125.748 |
| 61 | -113.606496 | | -42.705724 | SIO2V190 | 1.56082901 | 95.336 |
| 62 | -219.165708 | | -1.046852 | AIR | 1.00000000 | 88.880 |
| 63 | -176.523661 | | -46.935269 | SIO2V190 | 1.56082901 | 85.284 |
| 64 | -18730.408204 | AS | -0.898772 | AIR | 1.00000000 | 65.349 |
| 65 | -163.040688 | | -48.584179 | SIO2V190 | 1.56082901 | 53.269 |
| 66 | 0.000000 | | -3.000000 | H2OV193B | 1.43662694 | 17.465 |
| 67 | | | | | | 14.248 |

**Table 18A**

| Aspherical Constants | | | | | |
|---|---|---|---|---|---|
| SRF | 2 | 4 | 7 | 9 | 15 |
| K | 0 | 0 | 0 | 0 | 0 |
| C1 | -9.726701e-08 | -7.626716e-08 | -2.711559e-07 | -4.487932e-08 | 5.365072e-08 |
| C2 | -1.595385e-12 | 3.437654e-12 | 1.325705e-10 | -8.402981e-12 | 5.629273e-13 |
| C3 | 5.330794e-16 | -2.712927e-16 | -3.493922e-14 | 2.858435e-16 | -1.008441e-17 |
| C4 | -2.845127e-20 | -6.978902e-20 | 2.496448e-17 | -2.286853e-20 | -2.441211e-21 |
| C5 | -1.165868e-24 | 1.338682e-23 | -4.142042e-21 | 8.417173e-25 | 1.431360e-25 |
| C6 | 2.821709e-28 | -1.128335e-27 | 4.899449e-25 | -5.789405e-29 | -2.161204e-30 |

(continued)

| Aspherical Constants | | | | | |
|---|---|---|---|---|---|
| SRF | 2 | 4 | 7 | 9 | 15 |
| K | 0 | 0 | 0 | 0 | 0 |
| C7 | 0.000000e+00 | 0.000000e+00 | 0.000000e+00 | 0.000000e+00 | 0.000000e+00 |
| C8 | 0.000000e+00 | 0.000000e+00 | 0.000000e+00 | 0.000000e+00 | 0.000000e+00 |
| C9 | 0.000000e+00 | 0.000000e+00 | 0.000000e+00 | 0.000000e+00 | 0.000000e+00 |
| | | | | | |
| SRF | 17 | 19 | 26 | 28 | 38 |
| K | 0 | 0 | 0 | 0 | 0 |
| C1 | 2.390088e-08 | -2.509135e-10 | -9.106633e-09 | -9.106633e-09 | -6.872392e-08 |
| C2 | 6.269365e-13 | -5.455877e-15 | 4.666703e-14 | 4.686703e-14 | -2.538536e-13 |
| C3 | 6.975075e-19 | 1.552686e-19 | -1.447792e-18 | -1.447792e-18 | -2.505300e-17 |
| C4 | 4.897430e-22 | -4.350646e-24 | -7.890732e-23 | -7.890732e-23 | -8.960245e-22 |
| C5 | -4 560007e-26 | 6.564505e-29 | 5.205152e-27 | 5.205152e-27 | 4.485086e-26 |
| C6 | 7 088504e-31 | -4.840307e-34 | -1.056934e-31 | -1.056934e-31 | -2.610963e-30 |
| C7 | 0.000000e+00 | 0.000000e+00 | 0.000000e+00 | 0.000000e+00 | 0,000000e+00 |
| C8 | 0.000000e+00 | 0.000000e+00 | 0.000000e+00 | 0.000000e+00 | 0.000000e+00 |
| C9 | 0.000000e+00 | 0.000000e+00 | 0.000000e+00 | 0.000000e+00 | 0.000000e+00 |
| | | | | | |
| SRF | 42 | 43 | 46 | 47 | 49 |
| K | 0 | 0 | 0 | 0 | 0 |
| C1 | 4.774958e-08 | -3.617872e-07 | -7.552911e-08 | 1.098242e-07 | 1.868453e-08 |
| C2 | -4.656963e-11 | -7.364858e-11 | -9.867546e-12 | -2.279974e-12 | 2.297019e-12 |
| C3 | -3.560045e-15 | -4.936851e-15 | -6.896859e-16 | -1.670874e-16 | -1.240199e-16 |
| C4 | -2162341e-18 | -7.498172e-19 | 7.053064e-20 | 5.118348e-20 | 1.616012e-21 |
| C5 | 4.908109e-22 | 5.770269e-22 | 1.470664e-25 | -7.820077e-24 | -1.053620e-25 |
| C6 | -1.252006e-25 | -1.076810e-25 | -3.432956e-29 | 3.155236e-28 | 9.523235e-30 |
| C7 | 0.000000e+00 | 0.000000e+00 | 0,000000e+00 | 0.000000e+00 | 0.000000e+00 |
| C8 | 0.000000e+00 | 0.000000e+00 | 0,000000e+00 | 0.000000e+00 | 0.000000e+00 |
| C9 | 0.000000e+00 | 0.000000e+00 | 0.000000e+00 | 0.000000e+00 | 0.000000e+00 |
| | | | | | |
| SRF | 52 | 54 | 59 | 60 | 64 |
| K | 0 | 0 | 0 | 0 | 0 |
| C1 | 4.792024e-09 | -5.431959e-08 | -5.129307e-08 | -1.318238e-08 | -9.815987e-08 |
| C2 | 1.447096e-12 | 1.969482e-12 | 5.869243e-12 | 2.556218e-12 | -1.092901e-11 |
| C3 | -8.201118e-17 | 3.685626e-17 | -8.549744e-17 | 3.510279e-17 | 3.540037e-15 |
| C4 | -4.315298e-22 | 8.778723e-22 | 5.680092e-21 | -5.241894e-22 | -6.442268e-19 |
| C5 | 3 316156e-25 | -4.377851e-25 | -2.887059e-25 | -1.022382e-25 | 7.695400e-23 |
| C6 | -2.240183e-29 | 1.784961e-29 | 5.312147e-30 | 5.173743e-30 | -4.644590e-27 |

(continued)

| Aspherical Constants | | | | | |
|---|---|---|---|---|---|
| SRF | 2 | 4 | 7 | 9 | 15 |
| K | 0 | 0 | 0 | 0 | 0 |
| C7 | 0.000000e+00 | 0.000000e+00 | 0.000000e+00 | 0.000000e+00 | 0.000000e+00 |
| C8 | 0.000000e+00 | 0.000000e+00 | 0.000000e+00 | 0.000000e+00 | 0.000000e+00 |
| C9 | 0.000000e+00 | 0.000000e+00 | 0.000000e+00 | 0.000000e+00 | 0.000000e+00 |

**Table 19**

| $\lambda$=193 nm, NA=1.45, A=3 mm, B= 26 mm und C=6,75 | | | | | | |
|---|---|---|---|---|---|---|
| Surface | Radius | | Thickness | Material | Index at 193.368 nm | Semidiameter |
| 0 | 0.000000 | | 29.999023 | AIR | 1.00000000 | 65.000 |
| 1 | 0.000000 | | 46.130615 | AIR | 1.00000000 | 76.736 |
| 2 | -274.755776 | AS | 22.345935 | SIO2V190 | 1.56082901 | 87.538 |
| 3 | -156.680629 | | 0.897600 | AIR | 1.00000000 | 92.292 |
| 4 | 206.145156 | AS | 52.154618 | SIO2V190 | 1.56082901 | 113.209 |
| 5 | -1541.452312 | | 74.304392 | AIR | 1.00000000 | 112.058 |
| 6 | 91.536393 | | 57.499673 | SIO2V190 | 1.56082901 | 80.718 |
| 7 | -751.484909 | AS | 4.669206 | AIR | 1.00000000 | 74.778 |
| 8 | -3940.620388 | | 36.951820 | SIO2V190 | 1.56082901 | 69.793 |
| 9 | 111562.508620 | AS | 5.726093 | AIR | 1.00000000 | 48.260 |
| 10 | 0.000000 | | 0.000000 | AIR | 1.00000000 | 48.665 |
| 11 | 0.000000 | | 4.193018 | AIR | 1.00000000 | 48.665 |
| 12 | 0.000000 | | 17.297299 | SIO2V190 | 1.56082901 | 49.953 |
| 13 | 0.000000 | | 31.750987 | AIR | 1.00000000 | 53.267 |
| 14 | -67.779748 | | 10.000285 | SIO2V190 | 1.56082901 | 54.555 |
| 15 | -186.587550 | AS | 7.481830 | AIR | 1.00000000 | 68.059 |
| 16 | -4841.461609 | | 26.723034 | SIO2V190 | 1.56082901 | 84.706 |
| 17 | -146.291325 | AS | 41.145606 | AIR | 1.00000000 | 89.573 |
| 18 | -334.441990 | AS | 62.037590 | SIO2V190 | 1.56082901 | 110.860 |
| 19 | -126.842135 | | 152.474091 | AIR | 1.00000000 | 115.982 |
| 20 | 0.000000 | | -76.027367 | REFL | 1.00000000 | 160.768 |
| 21 | 213.987855 | AS | 123.527367 | REFL | 1.00000000 | 149.923 |
| 22 | 0.000000 | | -123.527367 | REFL | 1.00000000 | 47.868 |
| 23 | 213.987855 | AS | 77.527367 | REFL | 1.00000000 | 150.772 |
| 24 | 0.000000 | | -195.978976 | REFL | 1.00000000 | 160.964 |
| 25 | 0.000000 | | -0.898147 | AIR | 1.00000000 | 116.050 |
| 26 | -219.428225 | | -47.467841 | SIO2V190 | 1.56082901 | 118.560 |
| 27 | 1659.037279 | AS | -90.089470 | AIR | 1.00000000 | 117.211 |
| 28 | 435.230175 | AS | -9.996036 | SIO2V190 | 1.56082901 | 88.268 |

(continued)

| λ=193 nm, NA=1.45, A=3 mm, B= 26 mm und C=6,75 | | | | | | |
|---|---|---|---|---|---|---|
| Surface | Radius | | Thickness | Material | Index at 193.368 nm | Semidiameter |
| 29 | -387.925252 | | -30.801725 | AIR | 1.00000000 | 86.548 |
| 30 | 231.813556 | | -9.995123 | SIO2V190 | 1.56082901 | 86.711 |
| 31 | -124.179167 | AS | -52.975916 | AIR | 1.00000000 | 96.726 |
| 32 | 239.371989 | AS | -18.556461 | SIO2V190 | 1.56082901 | 100.956 |
| 33 | 243.755943 | | -0.896195 | AIR | 1.00000000 | 106.781 |
| 34 | -358.914000 | | -61.687114 | SIO2V190 | 1.56082901 | 146.323 |
| 35 | 192.587345 | AS | -18.507831 | AIR | 1.00000000 | 147.785 |
| 36 | 973.783364 | AS | -19.367336 | SIO2V190 | 1.56082901 | 150.865 |
| 37 | 353.236414 | | -1.492183 | AIR | 1.00000000 | 156.546 |
| 38 | 304.657877 | AS | -40.674752 | SIO2V190 | 1.56082901 | 159.687 |
| 39 | 255.232566 | | -0.897985 | AIR | 1.00000000 | 162.744 |
| 40 | -732.968915 | AS | -43.526593 | SIO2V190 | 1.56082901 | 169.987 |
| 41 | 1469.635254 | AS | -75.623622 | AIR | 1.00000000 | 170.107 |
| 42 | 0.000000 | | 0.000000 | AIR | 1.00000000 | 160.981 |
| 43 | 0.000000 | | 74.659649 | AIR | 1.00000000 | 160.981 |
| 44 | -205.937419 | | -41.872445 | SIO2V190 | 1.56082901 | 161.034 |
| 45 | -235.289542 | AS | -0.894334 | AIR | 1.00000000 | 157.398 |
| 46 | -190.410058 | AS | -57.280435 | SIO2V190 | 1.56082901 | 152.560 |
| 47 | -843.127222 | AS | -0.889225 | AIR | 1.00000000 | 147.649 |
| 48 | -142.631884 | AS | -56.442477 | SIO2V190 | 1.56082901 | 109.136 |
| 49 | -1611.254652 | AS | -0.865149 | AIR | 1.00000000 | 99.734 |
| 50 | -59.300481 | | -55.374054 | LIBAF | 1.64082901 | 55.711 |
| 51 | 0.000000 | | -4.274244 | HINDLIQ | 1.65000000 | 24.245 |
| 52 | | | | | | 16.252 |

**Table 19A**

| Aspherical Constants | | | | | |
|---|---|---|---|---|---|
| SRF | 2 | 4 | 7 | 9 | 15 |
| K | 0 | 0 | 0 | 0 | 0 |
| C1 | -6.183815e-08 | 2.882263e-08 | -5.823070e-08 | 3.225386e-07 | -1.124138e-07 |
| C2 | -3.532396e-12 | 2.473745e-12 | 1.024958e-10 | -1.695662e-11 | -1.774229e-11 |
| C3 | 6.082699e-16 | -3.882686e-16 | -3.340502e-14 | -1.951585e-14 | 1.786772e-16 |
| C4 | -6.705201e-20 | 2.736304e-20 | 8.074522e-18 | 2.456991e-17 | 8.125504e-19 |
| C5 | 4.766345e-24 | -1.051217e-24 | -1.476575e-21 | -1.725447e-20 | -1.940588e-22 |
| C6 | -1.677158e-28 | 1.118144e-29 | 1.915552e-25 | 8.084938e-24 | 6.701572e-26 |
| C7 | -2.238382e-33 | 6.864559e-34 | -1.556221e-29 | -2.180145e-27 | -1.030631e-29 |
| C8 | 1.944268e-37 | -2.079703e-38 | 6.136886e-34 | 2.543487e-31 | 1.020664e-33 |

(continued)

| Aspherical Constants | | | | | |
|---|---|---|---|---|---|
| SRF | 2 | 4 | 7 | 9 | 15 |
| K | 0 | 0 | 0 | 0 | 0 |
| C9 | 0.000000e+00 | 0.000000e+00 | 0.000000e+00 | 0.000000e+00 | 0.000000e+00 |
| | | | | | |
| SRF | 17 | 18 | 21 | 23 | 27 |
| K | 0 | 0 | -1.90513 | -1.90513 | 0 |
| C1 | 1.655604e-07 | -1.779528e-08 | 1.714098e-08 | 1.714098e-08 | -1.802101e-09 |
| C2 | 1.341348e-11 | -8.687320e-13 | -9.102492e-14 | -9.102492e-14 | 5.947549e-13 |
| C3 | 6.997752e-17 | 7.357742e-17 | 1.275136e-18 | 1.275136e-18 | -1.151142e-18 |
| C4 | -7.155381e-20 | -1.063072e-20 | -3.449801e-24 | -3.449801e-24 | -2.050544e-21 |
| C5 | -2.395092e-23 | 1.724877e-24 | -1.217822e-28 | -1.217822e-28 | 2.266817e-25 |
| C6 | 4.912984e-27 | -1.676805e-28 | -1.330655e-32 | -1.330655e-32 | -1.593141e-29 |
| C7 | -3.951181e-31 | 8.838571e-33 | 8.395793e-37 | 8.395793e-37 | 6.386068e-34 |
| C8 | 1.223590e-35 | -2.159628e-37 | -1.340467e-41 | -1.340467e-41 | -1.097985e-38 |
| C9 | 0.000000e+00 | 0.000000e+00 | 0.000000e+00 | 0.000000e+00 | 0.000000e+00 |
| | | | | | |
| SRF | 28 | 31 | 32 | 35 | 36 |
| K | 0 | 0 | 0 | 0 | 0 |
| C1 | -8.274846e-08 | 2.167366e-08 | -6.685472e-08 | -1.030825e-07 | 1.134672e-07 |
| C2 | 1.99666we-11 | 2.679193e-11 | 1.292577e-12 | 1.628496e-14 | -4.087619e-12 |
| C3 | -1.404659e-15 | -2.921776e-15 | -2.352826e-16 | 1.527367e-16 | 1.561257e-16 |
| C4 | 9.601306e-20 | 2.528260e-19 | 3.824982e-20 | -1.357385e-20 | -9.019124e-21 |
| C5 | -2.342213e-24 | -1.288773e-23 | -5.597975e-24 | 5.061736e-25 | 1.488385e-25 |
| C6 | -4.655839e-28 | 2.665175e-28 | 5.525972e-28 | -9.404023e-30 | 4.434443e-30 |
| C7 | 6.011793e-32 | 1.088959e-32 | -3.612068e-32 | -4.280587e-35 | -1.790396e-34 |
| C8 | -2.584646e-36 | -3.706675e-37 | 1.064822e-36 | 3.258287e-39 | 1.318994e-39 |
| C9 | 0.000000e+00 | 0.000000e+00 | 0.000000e+00 | 0.000000e+00 | 0.000000e+00 |
| | | | | | |
| SRF | 38 | 40 | 41 | 45 | 46 |
| K | 0 | 0 | 0 | 0 | 0 |
| C1 | -8.524427e-08 | 4.394694e-09 | 6.976341e-08 | 2.526204e-08 | 5.795020e-08 |
| C2 | 3.749840e-12 | -1.117774e-16 | -4.973804e-12 | 1.148192e-12 | 1.511108e-12 |
| C3 | -1.610273e-16 | -2.059022e-18 | 1.961798e-16 | -1.172011e-16 | -2.660364e-16 |
| C4 | 1.095019e-20 | 6.972148e-22 | -6.177844e-21 | -1.025779e-21 | 5.336844e-21 |
| C5 | -5.682955e-25 | -1.522351e-27 | 1.924452e-25 | 2.356707e-25 | 2.132008e-25 |
| C6 | 1.943533e-29 | -8.886351e-31 | -3.949242e-30 | 3.158979e-30 | -7.251682e-30 |
| C7 | -3.917378e-34 | 3.841859e-36 | 2.087721e-35 | -4.042612e-34 | 4.082502e-35 |
| C8 | 3.312900e-39 | 2.522002e-40 | 2.993482e-40 | 5.893449e-39 | -5.284191e-41 |

(continued)

| Aspherical Constants | | | | | |
|---|---|---|---|---|---|
| SRF | 2 | 4 | 7 | 9 | 15 |
| K | 0 | 0 | 0 | 0 | 0 |
| C9 | 0.000000e+00 | 0.000000e+00 | 0.000000e+00 | 0.000000e+00 | 0.000000e+00 |
| | | | | | |
| SRF | 47 | 48 | 49 | | |
| K | 0 | 0 | 0 | | |
| C1 | 4.123202e-08 | 2.563108e-08 | -4.312873e-08 | | |
| C2 | -1.396443e-12 | -1.002534e-11 | -6.665686e-12 | | |
| C3 | -3.413288e-17 | 7.711208e-16 | 1.097405e-15 | | |
| C4 | 2.611714e-22 | -3.475519e-20 | -2.220246e-19 | | |
| C5 | 2.532171e-25 | -2.269758e-24 | 2.606167e-23 | | |
| C6 | -1.541330e-29 | 2.647026e-28 | -2.117967e-27 | | |
| C7 | 3.328368e-34 | -1.257282e-32 | 1.088024e-31 | | |
| C8 | -2.388543e-39 | 1.892747e-38 | -2.526456e-36 | | |
| C9 | 0.000000e+00 | 0.000000e+00 | 0.000000e+00 | | |

**Table 20**

| $\lambda$=193 nm, NA=1.53, A=2,75 mm, B= 26 mm und C=7 | | | | | | |
|---|---|---|---|---|---|---|
| Surface | Radius | | Thickness | Material | Index at 193.368 nm | Semidiameter |
| 0 | 0.000000 | | 29.999023 | AIR | 1.00000000 | 65.000 |
| 1 | 0.000000 | | 62.424462 | AIR | 1.00000000 | 72.000 |
| 2 | -275.549622 | AS | 29.481809 | SIO2V190 | 1.56082901 | 88.533 |
| 3 | -141.396443 | | 0.895289 | AIR | 1.00000000 | 95.956 |
| 4 | 311.180538 | AS | 61.406057 | SIO2V190 | 1.56082901 | 130.000 |
| 5 | -670.625558 | | 56.250262 | AIR | 1.00000000 | 130.000 |
| 6 | 101.043296 | | 71.493623 | SIO2V190 | 1.56082901 | 90.000 |
| 7 | -526.780533 | AS | 7.484812 | AIR | 1.00000000 | 90.000 |
| 8 | 282.569437 | | 11.864903 | SIO2V190 | 1.56082901 | 59.576 |
| 9 | 138.402661 | AS | 14.794180 | AIR | 1.00000000 | 47.898 |
| 10 | 0.000000 | | 0.000000 | AIR | 1.00000000 | 45.938 |
| 11 | 0.000000 | | 10.671944 | AIR | 1.00000000 | 45.938 |
| 12 | 0.000000 | | 9.994967 | SIO2V190 | 1.56082901 | 50.166 |
| 13 | 0.000000 | | 33.485401 | AIR | 1.00000000 | 52.593 |
| 14 | -102.270111 | | 16.693323 | SIO2V190 | 1.56082901 | 70.000 |
| 15 | -430.261491 | AS | 0.955003 | AIR | 1.00000000 | 80.000 |
| 16 | -661.622339 | | 34.517242 | SIO2V190 | 1.56082901 | 95.000 |
| 17 | -225.058598 | AS | 25.518820 | AIR | 1.00000000 | 95.000 |
| 18 | -4184.457144 | AS | 69.140666 | SIO2V190 | 1.56082901 | 120.000 |

(continued)

| λ=193 nm, NA=1.53, A=2,75 mm, B= 26 mm und C=7 | | | | | |
|---|---|---|---|---|---|
| Surface | Radius | | Thickness | Material | Index at 193.368 nm | Semidiameter |
| 19 | -138.740353 | | 151.452338 | AIR | 1.00000000 | 120.000 |
| 20 | 0.000000 | | -79.825706 | REFL | 1.00000000 | 151.767 |
| 21 | 219.613473 | AS | 126.325706 | REFL | 1.00000000 | 142.966 |
| 22 | 0.000000 | | -126.325706 | REFL | 1.00000000 | 42.359 |
| 23 | 219.613473 | AS | 81.325706 | REFL | 1.00000000 | 141.228 |
| 24 | 0.000000 | | -194.976350 | REFL | 1.00000000 | 154.553 |
| 25 | 0.000000 | | -0.896406 | AIR | 1.00000000 | 111.839 |
| 26 | -164.320614 | | -55.504648 | SIO2V190 | 1.56082901 | 120.000 |
| 27 | -1229.896821 | AS | -90.610108 | AIR | 1.00000000 | 120.000 |
| 28 | 265.438189 | AS | -9.994536 | SIO2V190 | 1.56082901 | 92.000 |
| 29 | 4315.161396 | | -20.736055 | AIR | 1.00000000 | 92.000 |
| 30 | 237.019337 | | -9.993848 | SIO2V190 | 1.56082901 | 100.000 |
| 31 | -125.192600 | AS | -55.944817 | AIR | 1.00000000 | 100.000 |
| 32 | 269.247396 | AS | -16.727804 | SIO2V190 | 1.56082901 | 99.817 |
| 33 | 232.364846 | | -0.940363 | AIR | 1.00000000 | 105.746 |
| 34 | -402.269344 | | -58.210006 | SIO2V190 | 1.56082901 | 143.473 |
| 35 | 193.826487 | AS | -9.292015 | AIR | 1.00000000 | 145.375 |
| 36 | 986.868461 | AS | -20.034329 | SIO2V190 | 1.56082901 | 147.013 |
| 37 | 326.097076 | | -4.697875 | AIR | 1.00000000 | 150.171 |
| 38 | 319.290644 | AS | -47.256988 | SIO2V190 | 1.56082901 | 152.978 |
| 39 | 221.922484 | | -1.877923 | AIR | 1.00000000 | 156.306 |
| 40 | -735.168139 | AS | -41.044934 | SIO2V190 | 1.56082901 | 160.682 |
| 41 | 1866.076674 | AS | -61.087568 | AIR | 1.00000000 | 161.504 |
| 42 | 0.000000 | | 0.000000 | AIR | 1.00000000 | 142.049 |
| 43 | 0.000000 | | 56.407968 | AIR | 1.00000000 | 142.049 |
| 44 | -199.327051 | | -30.095173 | SIO2V190 | 1.56082901 | 141.829 |
| 45 | -225.926335 | AS | -4.214699 | AIR | 1.00000000 | 138.315 |
| 46 | -191.876452 | AS | -48.531392 | SIO2V190 | 1.56082901 | 135.906 |
| 47 | -720.014602 | AS | -0.901346 | AIR | 1.00000000 | 131.792 |
| 48 | -121.344762 | AS | -48.390894 | SIO2V190 | 1.56082901 | 97.106 |
| 49 | -830.014070 | AS | -0.890801 | AIR | 1.00000000 | 86.989 |
| 50 | -75.937252 | | -59.614292 | SPINELL | 1.91082901 | 62.119 |
| 51 | 0.000000 | | -4.274244 | HINDLIQ | 1.65000000 | 25.508 |
| 52 | | | | | | 14.885 |

**Table 20A**

| Aspherical Constants | | | | | |
|---|---|---|---|---|---|
| SRF | 2 | 4 | 7 | 9 | 15 |
| K | 0 | 0 | 0 | 0 | 0 |
| C1 | -1 541662e-07 | 8.557181e-08 | -1.888568e-07 | 4.226875e-07 | -1.918858e-07 |
| C2 | 5.986635e-12 | -3.469393e-12 | 1.181416e-10 | -4.737776e-11 | 1.145332e-12 |
| C3 | -4.068105e-16 | 5.284919e-17 | -2.930865e-14 | 2.415248e-14 | -9.995293e-16 |
| C4 | -1.110437e-20 | 1.069774e-20 | 5.480485e-18 | -1.819371e-17 | 2.017521e-19 |
| C5 | 5.475851e-24 | -1.170001e-24 | -7.493526e-22 | 1.744989e-20 | -1.348428e-23 |
| C6 | -8.325003e-28 | 5.685074e-29 | 7.221250e-26 | -1.024094e-23 | 1.989655e-27 |
| C7 | 6.515249e-32 | -1.414058e-33 | -4.314550e-30 | 3.237436e-27 | -2.906508e-31 |
| C8 | -2.184607e-36 | 1.452370e-38 | 1.184860e-34 | -4.053406e-31 | 2.558997e-35 |
| C9 | 0.000000e+00 | 0.000000e+00 | 0.000000e+00 | 0.000000e+00 | 0.000000e+00 |
| | | | | | |
| SRF | 17 | 18 | 21 | 23 | 27 |
| K | 0 | 0 | -1.90513 | -1.90513 | 0 |
| C1 | 1.061029e-07 | -2.180078e-08 | 1.572155e-08 | 1.572155e-08 | -7.535002e-09 |
| C2 | 6.214938e-12 | 2.788218e-13 | -8.043579e-14 | -8.043579e-14 | 4.521909e-13 |
| C3 | -1.480977e-16 | 1.216139e-18 | 1.215429e-18 | 1.215429e-18 | 1.461647e-17 |
| C4 | -8.628328e-21 | -7.838845e-22 | -3.463288e-24 | -3.463288e-24 | -1.773375e-21 |
| C5 | -1.441482e-23 | 1.099901e-25 | -4.229631e-28 | -4.229631e-28 | 1.533645e-25 |
| C6 | 2.480732e-27 | -8.089639e-30 | 2.392176e-32 | 2.392176e-32 | -8.786092e-30 |
| C7 | -1.637800e-31 | 2.959407e-34 | -5.778997e-37 | -5.778997e-37 | 2.366843e-34 |
| C8 | 4.060135e-36 | -4.799332e-39 | 5.885806e-42 | 5.885806e-42 | -2.217476e-39 |
| C9 | 0.000000e+00 | 0.000000e+00 | 0.000000e+00 | 0.000000e+00 | 0.000000e+00 |
| | | | | | |
| SRF | 28 | 31 | 32 | 35 | 36 |
| K | 0 | 0 | 0 | 0 | 0 |
| C1 | -3.248296e-08 | 8.218395e-08 | -1.412661e-08 | -1.024960e-07 | 9.566043e-08 |
| C2 | 1.639671e-11 | 1.092796e-11 | 1.202616e-12 | 2.362238e-13 | -3.161220e-12 |
| C3 | -7.189403e-16 | -1.736324e-15 | -1.229901e-16 | 1.142480e-16 | 8.991937e-17 |
| C4 | 3.907642e-20 | 3.178419e-19 | 1.585417e-20 | -1.241322e-20 | -5.787004e-21 |
| C5 | -8 036786e-25 | -4.089077e-23 | -1.970378e-24 | 5.476989e-25 | 1.836109e-25 |
| C6 | -1.243033e-28 | 4.107583e-27 | 8.629836e-29 | -1.420907e-29 | -5.522384e-30 |
| C7 | -3.573592e-32 | -2.583858e-31 | 4.575961 e-34 | 1.559819e-34 | -1.358370e-35 |
| C8 | 2.492896e-36 | 7.038947e-36 | -2.373623e-37 | 1.784353e-39 | 4.927633e-39 |
| C9 | 0.000000e+00 | 0.000000e+00 | 0.000000e+00 | 0.000000e+00 | 0.000000e+00 |
| | | | | | |
| SRF | 38 | 40 | 41 | 45 | 46 |
| K | 0 | 0 | 0 | 0 | 0 |

(continued)

| Aspherical Constants | | | | | |
| --- | --- | --- | --- | --- | --- |
| SRF | 2 | 4 | 7 | 9 | 15 |
| K | 0 | 0 | 0 | 0 | 0 |
| C1 | -8.948978e-08 | 2.804102e-09 | 5.523657e-08 | 2.899643e-08 | 8.098960e-08 |
| C2 | 4.359222e-12 | 3.439409e-13 | -4.223545e-12 | 2.060649e-12 | -1.405107e-13 |
| C3 | -1.784446e-16 | -1.252513e-18 | 2.114959e-16 | -1.697800e-16 | -2.361777e-16 |
| C4 | 1.074022e-20 | 7.377292e-22 | -6.791341e-21 | -6.715515e-22 | 5.852941e-21 |
| C5 | -5.243168e-25 | 3.459555e-27 | 2.078713e-25 | 1.921340e-25 | 1.972610e-25 |
| C6 | 1.889468e-29 | -1.649267e-30 | -3.173268e-30 | 2.995748e-30 | -1.418678e-29 |
| C7 | -4.281638e-34 | 2.700808e-35 | -3.487366e-35 | -4.137617e-34 | 1.466808e-34 |
| C8 | 5.066622e-39 | 1.560845e-40 | 1.205300e-39 | 9.730165e-39 | 5.850027e-39 |
| C9 | 0.000000e+00 | 0.000000e+00 | 0.000000e+00 | 0.000000e+00 | 0.000000e+00 |
| | | | | | |
| SRF | 47 | 48 | 49 | | |
| K | 0 | 0 | 0 | | |
| C1 | 6.111963e-08 | 1.323564e-08 | -1.284100e-07 | | |
| C2 | -1.349597e-12 | -5.789596e-12 | -1.316056e-12 | | |
| C3 | -7.140246e-17 | 5.678195e-16 | 4.433506e-18 | | |
| C4 | -1.224010e-22 | -5.309376e-20 | -5.664625e-20 | | |
| C5 | 2.781825e-25 | 3.130440e-24 | 1.454058e-23 | | |
| C6 | -1.688179e-29 | -4.666638e-28 | -2.939687e-27 | | |
| C7 | 6.571289e-34 | 5.613107e-32 | 2.229781e-31 | | |
| C8 | -1.241910e-38 | -4.227827e-36 | -7.320703e-36 | | |
| C9 | 0.000000e+00 | 0.000000e+00 | 0.000000e+00 | | |

## Claims

1. An optical system forming an image of a pattern provided in an object plane of the optical system in an image plane of the optical system, comprising:

   a plurality of non-parallel optical axis segments;
   a plurality of intermediate images; and
   a plurality of mirrors;

   wherein radiation emerging from a first intermediate image is incident in this order on a first mirror positioned optically remote from a pupil position, a second mirror positioned optically near to a pupil position to form a pupil mirror, and a third mirror positioned optically remote from a pupil position, prior to forming a second intermediate image, wherein the first mirror a first concave mirror, and the third mirror is a second concave mirror.

2. An optical system according to claim 1, comprising:

   (i) a first dioptric imaging system forming an intermediate image and a second catadioptric imaging system forming a final image in the image plane;
   or
   (ii) a first catadioptric imaging system forming an intermediate image and a second dioptric imaging system forming the final image, wherein the first catadioptric objective part comprises the first mirror, the second mirror, and the third mirror;

or

(iii) a first dioptric imaging system forming an intermediate image, a second catadioptric or catoptric imaging system forming a second intermediate image, and a third dioptric imaging system forming the final image, wherein the second catadioptric objective part comprises the first mirror, the second mirror, and the third mirror;

or

(iv) a first catadioptric imaging system forming an intermediate image, and a second catadioptric imaging system forming the final image;

or

(v) a first catadioptric imaging system forming an intermediate image and a second catadioptric imaging system forming a further intermediate and a third catadioptric imaging system forming the final image.

3. Optical system according to one of claims 1 or 2, wherein the first mirror optically remote from the pupil position and the third mirror optically remote from the pupil position are identical in shape and are formed on a single mirror substrate used twice in laterally offset reflecting areas, wherein preferably the reflecting areas do not overlap.

4. Optical system according to one of claims 1 to 3, wherein the pupil mirror is a substantially planar mirror.

5. Optical system according to one of claims 1 to 3, wherein the pupil mirror is a concave mirror.

6. Optical system according to one of claims 1 to 6, wherein an intermediate image is formed optically between the first mirror positioned optically remote from a pupil position and the pupil mirror, and/or wherein an intermediate image is formed optically between the pupil mirror and the third mirror positioned optically remote from a pupil position.

7. Optical system according to one of the preceding claims, further comprising a negative group having at least one negative lens immediately in front of the pupil mirror in a region passed twice by radiation.

8. Optical system according to one of the preceding claims, comprising at least two planar folding mirrors.

9. Optical system according to one of the preceding claims, comprising a first objective part forming the first intermediate image, a second objective part forming a second intermediate image from the first intermediate image and comprising at least one concave mirror, and a third objective part forming the image in the image plane from the second intermediate image, wherein preferably the optical system comprises exactly two intermediate images and/or wherein the second objective part includes the first mirror positioned optically remote from the second pupil surface, the second mirror positioned optically near to the second pupil surface to form the pupil mirror, and the third mirror positioned optically remote from a pupil position.

10. Optical system according to one of the preceding claims, comprising two mirrors near a pupil surface position.

11. Optical system according to one of the preceding claims, further comprising a manipulation device including at least one optical element positioned near a pupil position in a double pass region passed twice by radiation in operation.

12. Optical system according to claim 11, wherein the manipulation device comprises at least one exchangeable optical element, wherein preferably the exchangeable optical element is positioned in front of the pupil mirror.

13. Optical system according to one of the preceding claims, further comprising a transparent manipulation element configured to vary a spatial distribution of refractive index in a time-dependent manner in response to electrical signals provided by a control unit, wherein preferably the transparent manipulation element includes a plurality of electrically conducting conductor tracks forming a plurality of electrically heatable heating zones distributed over a useful cross-section of the manipulation element in a two-dimensional array configuration and/or wherein the transparent manipulation element is positioned in front of the pupil mirror in a double pass region passed twice by radiation on its way to the pupil mirror, and from the pupil mirror.

14. Optical system according to one of the preceding claims, further comprising a pupil mirror manipulator operatively connected to the pupil mirror and configured to vary the shape of the pupil mirror surface.

15. Optical system according to one of the preceding claims, comprising an immersion lens group having a convex object-side entry surface bounding at a gas or vacuum and an image-side exit surface in contact with an immersion liquid in operation, wherein the immersion lens group is at least partly made of a high-index material with refractive index n ≥ 1.6 at the operating wavelength, wherein preferably the immersion lens group is a monolithic plano-convex lens made of the high-index material and/or wherein the high-index material is chosen from the group consisting of aluminum oxide ($Al_2O_3$), beryllium oxide (BeO), magnesium aluminum oxide ($MgAlO_4$, spinell), yttrium aluminium oxide ($Y_3Al_5O_{12}$), yttrium oxide ($Y_2O_3$), lanthanum fluoride ($LaF_3$), lutetium aluminium garnet (LuAG), magnesium oxide (MgO), calcium oxide (CaO), lithium barium fluoride ($LiBaF_3$).

16. Optical system according to one of the preceding claims, wherein all ray bundles within the optical system are located within a space defined as a cylinder around an optical axis segment defined by a final objective part closest to the image plane, the cylinder extending from the object surface to the image surface and having a maximum radius of the 1.5 fold of a maximum ray height within the final objective part.

17. A projection exposure apparatus comprising:

a light source generating primary radiation;
an illumination system forming the primary radiation to generate illumination radiation incident on a mask bearing a pattern;
an optical system according one of the preceding claims projecting an image of the pattern onto a radiation-sensitive substrate.

Fig. 1

Fig. 2

Fig. 3

Fig. 4

(a)                    (b)

Fig. 5

EP 2 136 231 A1

Fig. 6

Fig. 7

Fig 8 A

Fig. 8 B

Fig. 9

Fig. 10

(a)

(b)

Fig. 11

Fig. 12 A

Fig. 12 B

IMI1    FM1    PM    FM2    IMI 2

B3    CM1    B1    CM2    B2

Fig. 13

Y    OF

(a)    Fig. 14

X

OA

Z

A    B    A    B

Y    Y

C    C

X    X

OA    R    DOF    OA    DOF

(b)    (c)

EP 2 136 231 A1

Fig. 15

Fig. 16A

Fig. 16B

Fig. 17

Fig. 18

Fig. 19

EP 2 136 231 A1

OP1  OP2  OP3

IMI1  FM1  PM  FM2  IMI2

OS

CM1  CM2

IS

2000

Fig. 20

Europäisches
Patentamt

European
Patent Office

Office européen
des brevets

# EUROPEAN SEARCH REPORT

**Application Number**

EP 08 01 0944

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/262277 A1 (TAKAHASHI TOMOWAKI [JP]) 23 November 2006 (2006-11-23) | 1,17 | INV. G02B17/08 G03F7/20 |
| Y | * paragraph [0078]; figure 5 * | 2 | |
| Y | EP 1 852 745 A (ZEISS CARL SMT AG [DE]) 7 November 2007 (2007-11-07) * figure 1 * | 2 | |
| Y | US 4 701 035 A (HIROSE RYUSHO [JP]) 20 October 1987 (1987-10-20) * figure 12 * | 2 | |

**TECHNICAL FIELDS SEARCHED (IPC)**

G02B
G03F

~~The present search report has been drawn up for all claims~~

| Place of search | Date of completion of the search | Examiner |
|---|---|---|
| Munich | 6 October 2008 | Daffner, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

see annex

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 08 01 0944

The Search Division considers that the present European patentapplication does not comply with the requirements of unity of invention and relates to severalinventions or groups of inventions, namely:

```
1. claims: 1,2,17

        Combination of a catadioptric system with a dioptric system.
                    ---

2. claim: 3

        The first and the third mirror are integrated on a single
        substrate.
                    ---

3. claims: 4-10

                Optical design of the pupil mirror group.
                    ---

4. claims: 11 - 14

                Including a manipulating device.
                    ---

5. claim: 15

                An immersion lens
                    ---

6. claim: Constraining the optical system into a cylinder.


                    ---
```

## ANNEX TO THE EUROPEAN SEARCH REPORT
## ON EUROPEAN PATENT APPLICATION NO.

EP 08 01 0944

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2008

| Patent document cited in search report | | Publication date | Patent family member(s) | | Publication date |
|---|---|---|---|---|---|
| US 2006262277 | A1 | 23-11-2006 | EP<br>WO<br>KR | 1860477 A1<br>2006087978 A1<br>20070107126 A | 28-11-2007<br>24-08-2006<br>06-11-2007 |
| EP 1852745 | A | 07-11-2007 | JP<br>US | 2007298984 A<br>2008007822 A1 | 15-11-2007<br>10-01-2008 |
| US 4701035 | A | 20-10-1987 | NONE | | |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6252647 B1
- US 2006005026 A1
- US 20040169836 A
- US 5986795 A
- US 20060018045 A1
- EP 2007007093 W
- WO 2008034636 A2
- US 20060012885 A1